(19) Europäisches Patentamt / European Patent Office / Office européen des brevets

(11) **EP 3 196 950 A1**

(12) **EUROPEAN PATENT APPLICATION**
published in accordance with Art. 153(4) EPC

(43) Date of publication:
**26.07.2017 Bulletin 2017/30**

(51) Int Cl.:
**H01L 35/32** (2006.01)   **H01L 37/00** (2006.01)
**H02N 11/00** (2006.01)

(21) Application number: **15836637.7**

(22) Date of filing: **28.07.2015**

(86) International application number:
**PCT/JP2015/072812**

(87) International publication number:
**WO 2016/031572 (03.03.2016 Gazette 2016/09)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **23.08.2014 JP 2014183668**

(71) Applicant: **Mabuchi, Mahito
Kyoto-shi 600-8096 (JP)**

(72) Inventor: **ASHIDA, Yu
Kyoto-shi
Kyoto 601-1122 (JP)**

(74) Representative: **Guardian
IP Consulting I/S
Diplomvej, Building 381
2800 Kgs. Lyngby (DK)**

(54) **THERMOELECTRIC MATERIAL, THERMOELECTRIC CONVERSION ELEMENT, AND MODULE GROUP COMPOSED OF COMBINATION OF THERMOELECTRIC CONVERSION ELEMENTS AND -TYPE MODULE GROUP MADE OF THERMOELECTRIC MATERIAL AND -TYPE MODULE GROUP MADE OF THERMOELECTRIC MATERIAL OTHER THAN SUCH -TYPE MODULE GROUP**

(57)    The purpose of the present invention is to create a thermoelectric conversion system in which the thermoelectric conversion efficiency of a thermoelectric material is close to the Carnot efficiency, such thermoelectric material containing a "module group composed of a combination of thermoelectric conversion elements".

The invention reduces as much as possible the thermal conductivity from anything other than a space portion or a working substance able to move inside a thermoelectric conversion element due to a connected space portion, in a new generation of thermoelectric materials which comprise a "module group composed of a combination of thermoelectric conversion elements", and which are thermoelectric materials that do not suffer damage from a load or heat retention and that are composed of thermoelectric conversion elements that do not suffer damage from a load or heat retention. The invention comprises reforming thermoelectric material surfaces sandwiching a space, or surfaces facing this thermoelectric material, to make an interface that is suitable for power generation, cooling, and heating operation. The purpose of the present invention is to produce an interspecific module superior to a "module group composed of a combination of thermoelectric conversion elements" and in contact with three or more different heat bath sources at room temperature or the like, and to produce a thermoelectric conversion system that comprises this module and has a thermoelectric conversion efficiency close to the Carnot efficiency.

{Fig. 13}

## Description

## Technical Field

The present invention is directly connected with conversion method between thermal energy and electrical energy.

## Background Art

Power system converting thermal energy into electrical energy includes thermoelectric system using thermoelectric materials, thermionic system and/or so on. In converse process of using thermoelectric material as thermoelectric system, the thermoelectric material is also used as cooling system. The thermoelectric materials and the thermoelectric conversion elements defined in PTL 1 and PTL 2 are the materials that are utilized by good use of current transport phenomena with respect to both electric current and heat transfer amounts. In the thermoelectric materials (TMs) and thermoelectric conversion elements (TCEs) (hereafter, TMs and/or thermoelectric materials made from TMs, TCEs and are abbreviated as Thermoelectric-Materials, for the sake of simplicity), working substances (WSs) bearing the electric current of the current transport phenomena in the system are classical WS such as electrons, holes and so on analyzed by the classical mechanics, quantum WS in quantum effects becoming mainly significant in case at cryogenic temperature, or in addition to the above, in TCE WS is enlarged to that in thermoelectric macroscopic quantum materials. And in wide range of electrical conductivity from metals to insulators electric current transport phenomena has been utilized. TMs or the TCEs in which WS amount bearing electric current is larger than the heat transfer amount are good thermoelectric performance one. And a module or a system is composed of TMs and TCEs.

Performance of TCE in which electrons and/or holes are the classical WS is usually defined as figure-of-merit $Z$.:

{Math.1}
$$Z = {S^2}/{\kappa\rho} \cdot$$

the larger value of dimensionless figure-of-merit $ZT$.(where $T$. is the absolute temperature) of Thermoelectric-Material is, the better performance of its convertor between thermal and electrical energy is. Here $S$. represents Seebeck coefficient, $\kappa$. is thermal conductivity of sum of thermal conductivity $\kappa_c$. of the classical WS and lattice thermal conductivity $\kappa_{ph}$., and $\rho$. is the electrical resistivity of Thermoelectric-Material. In order to enlarge $ZT$. without changing $T$., it is good enough that the value of $S$. is enlarged and those of $\kappa$. and $\rho$. are made small. Because that electric heat characteristics of $S$., $\kappa$. and $\rho$.

are functions of density of the classical WS in Thermoelectric-Material, $S$. and $\rho$. are small and $\kappa$. is large in the case that density of the classical WS is high. According to theory of semiconductor, optimum density of electrons or holes for a working temperature range of Termoelectric-Material exists in order to have good performance. To improve the thermoelectric performance with respect to density of the classical WS, following three ways can be considered as:

1) Increase the density of the classical WS, and reduce $\rho$..
2) Reduce $\kappa_{ph}$. since $\kappa_c$. is proportional to $1/\rho$. from the Wiedemann-Franz law.
3) Increase $S$., by using Thermoelectric-Materials with large effective mass of the classical WS, i.e. electron or hole.

In the example of 1), a large amount of carrier is required to realize high electric conductivity. In flat band metals, due to the large Fermi surface and the asymmetry of electron-hole excitation, both high electric conductivity and large thermo electromotive force are obtained. Therefore, the thermoelectric performance is considerably improved. As an example, since layered cobalt oxide $Na_xCo_2$ have a large thermo electromotive force, material exploration of thermoelectric materials by screening using first principle band calculation and so on (NPL 1) has been performed.

Above mentioned $ZT$. is derived from using thermal equilibrium transport theory with respect to heat transfer amount and electric transfer in thermoelectric conversion elements. This theory is extended to the quantum WS.

It is for TMs to be desirable that $S$. is large, $\kappa$. is small similar to that of insulator and moreover $\rho$. is small similar to that of metal. Such the TMs element are manifested in 'a Phonon Glass and an Electron Crystal'; which aims at high migration materials that behave like crystal for both electron and hole moving, but like glass for lattice vibration. Such materials are found among compounds or their solid solutions of high density or degenerating of the classical WS, in addition reducing thermal conductivity due to $\kappa_{ph}$. is connected to high performance of TMs and TCEs.

Graphite, semimetals such arsenic, antimony, bismuth and the like which are group V of the periodic table, the 2H perovskite type calcium cobaltite and spinel type ruthenium cobaltite, in all of which are caused by electron-exchange reaction and disproportionation reaction between sites due to multiple mixed ion state, are in TMs of a hole-electron coexisting transition metal mixed oxide in a coexistence state of holes and electrons, and the like. And in case that the low temperature $Co_3O_4$ polycrystalline thin film is formed on an unheated glass substrate with $Ar/(Ar+O_2) < 3\%$ by RF magnetron sputtering method, the formed $Co_3O_4$ thin film is deficient in oxygen, and is close to an intrinsic semiconductor in which holes and electrons derived from oxygen deficiency coexist. When the holes and the electrons coexist, the net Seebeck coefficient becomes the sum $S_{Net} = (\sigma_h S_h + \sigma_e S_e)/\sigma$ of the Seebeck coefficient $S_h$ derived from the holes and the Seebeck coefficient $S_e$ derived from the electrons. Here, $\sigma_e$ and $\sigma_h$ are electric conductivity of the electron and the hole, respectively, and $\sigma$ is the net electric conductivity $\sigma = \sigma_h + \sigma_e$. Since $S_e$ is negative, absolute value of Seebeck coefficient coexisting electrons and holes decreases (NPL 2.)

It is known that Nernst effect as a WS flow magnetic effect in a TM or direct power generation and the like is an electromotive force from the temperature gradient and that Ettinghausen effect as the inverse process of the Nernst effect can obtain a temperature gradient from the electromotive force. The measurement results of a classical Nernst effect of In Sb and the Ettinghausen coefficient of bismuth single crystal have been published (NPL 3, 4, 5) In addition, those of theoretical analysis is divided the degree of freedom of motion of heat transfer and current amount in a magnetic field into degrees of freedom parallel to the magnetic field and perpendicular to the magnetic field in two-dimensional plane, these theoretical analyzes are carried by using thermal equilibrium transport theory relating to motion components in the two-dimensional plane (NPL 6.) A classical Nernst electromotive force $V_N$ is $V_N = WNB\nabla_x T$. Here, $W$ is a width of WM flows, $B$ is magnetic flux density, $N$ is Nernst coefficient and is defined as

{Math. 2}
$$N = (-S_{xy}\frac{\kappa_{xx}}{\kappa_{xy}} + S_{xx}).$$

Here $S_{xy}$ is the Seebeck coefficient when a direction of its heat flow is $x$ and that of WS is $\sigma_e$, $\kappa_{xx}$ is a thermal conductivity when direction of its heat flow is $x$ and that of WS is $y$. This theory is also extended the quantum WS.

In thermoelectric power generation utilizing, instead of the external magnetic field, "abnormalous Nernst effect" in which an electromotive force is generated in a direction orthogonal to both direction of magnetization and direction of heat flow of magnetic materials, direction of magnetization of the magnetic materials and direction of electromotive force generation of these can be in the same plane perpendicular to the heat flow of these, and it is possible to simplify manufacturing of these and to increase the area of these. Due to the abnormalous Nernst effect, FePt and MnGa having high magnetic anisotropy are oriented in opposite directions of electric field, by alternately arranging thin lines of these in parallel, electromotive force of these increase in proportion to the number of pairs of thermocuple serieses. And the direction of electric field due to the abnormalous Nernst effect is able to turn from side to side according to the direction magnetization of these. Even if they are made of same magnetic materials, if the directions of magnetization of these adjacent thin lines are alternately arranged, an abnormalous Nernst voltage of these can increase even if the external magnetic field of these is zero. Then, by changing fabrication conditions of FePt, two types of FePt lines (hard FePt films and soft FePt films) having inversely magnetic fields (the coercive force) in which the direction of magnetization are alternately arranged to fabricate a thermocouple, by inverting the magnetization of the FePt line having a small coercive force and then setting the magnetic field to zero, an antiparallel arrangement in which the magnetization directions of the adjacent FePt are reversed is obtained, because that abnormalous Nernst voltages appear alternately in the direction, it was shown that the electromotive force increased (NPL 7.)

According to NPL 8, if the length of $Bi_2Te_3$ wire is shorter than mean free path of phonons in $Bi_2Te_3$, the phonons parallel to direction of the length along the wire propagates ballistically in the wire. In case that heat transfer occurs parallel to the direction of length of the fine wire, phonon motion is characterized whether the length and/or the diameter of the fine wire are longer or shorter than the mean free path of the phonon. If the length and the diameter of the fine wire are longer than the mean free path of the phonon, the heat transfer is diffusive along the length and in the diameter according to the Fourier's law. If the diameter of the fine wire is less than the mean free path of the phonon, the phonons move ballistically in the diameter. But due to roughness of the inner surface of the fine wire, the heat transfer is smaller than that characterized by diffusive motion of the phonon. In case that the length of the fine wire is shorter than the mean free path of phonon and that the phonon motion is less affected by roughness of inner surface of the fine wire, the phonon also conducts ballistically along the length of the fine wire so that heat transfer in direction of the length is greater than that characterized by diffusive motion of phonon. On the other hand, using non-equilibrium molecular dynamics simulations, dependence of heat transfer on thickness of nanotube is evaluated in NPL 9. In single layered nanotube, roughness of the both inner surfaces is reduced so that phonon along the direction of the length moves ballistically up to $1.6\mu m$ at room temperature. As a result, length of heat transfer due to the phonon is enlarged that characterized by diffusive phonon motion. In geometrical low-dimension of TCE or layered TCE, cross section area in the direction of the thickness, through which electrons move, becomes so narrow that energy interval between electron states enlarges much more than thermal energy. And then electric conduction in the narrow cross section area almost vanished because that the electron density of states drastically changes due to the geometrical low-dimension and because that the electrons moving in the cross section are not scattered, and that along the length of the fine wire is enhanced. Examples of thermoelectric device based on the fact that figure-of-merit is improved due to geometrical low-dimension or layered TCEs are nano-sheet, super-lattice, nano-wire and so on.

Currently the most well-known and most widely used TCEs are chalcogenides such as $Bi_2Te_3$, $Bi_{2-x}Sb_xTe_3$ and $Bi_2Te_{3-x}Se_x$ and so on among semiconductor materials (NPL 9.) $ZT$. of these chalcogenide material in practical use is about 1 and it is considered to be the lower limit which can be profitable commercially at the present time. A practical TCE is limited to Bi-Te system in a low temperature range(about 500K) and Si-Ge system in a medium to high temperature range (about 800K). As new TCEs, layered cobalt oxide, clathrate compound, cage-like thermoelectric materials and TCEs using strong correlated electrons also exist. A high thermoelectric performance material called a skutteridoid compound ($CoSb_3$), silicade (metal silicade Mg-Si type, Na-Si type), oxide ($NaCo_2O_4$, $Ca_3Co_4O_9$ etc) and clathrate ($Ba_8Al_{16}Si_{30}$, $Ba_8Ga_{10}Si_{36}$, $Ba_8Ga_{16}Ge_{30}$ etc) have been developed. However, many of these constituent are composed of elements that are likely to be harmful to the human body and are rare elements, For this reason, it is necessary to make a cheper and environmentally friendly allow materials.

The crystal structure of $Mg_2Si$ is a cubic crystal structure and a $CaF_2$ type structure, and is an n type TCE having a peak of thermoelectric performance in the vicinity of 650 K. Replacing Mg with Ag, $Mg_2SiAg_{0.05}$ has-$1.8 < S < 0.5[mV]$.at$300 < T < 500[K]$.(NPL 10.)

The highest working temperature of PbTe-based compounds is about 950 K. The maximum Z is $1.7 \times 10^{-3}$ $K^{-1}$ at around 450K, in which electron density of n-type PbTe-based compounds is $5 \times 10^{\underline{24}}$ $m^{-3}$. Increasing the electron density from $5 \times 10^{\underline{25}}$ $m^{-3}$ makes the maximum Z gradually reduce in proportion to the electron density. In case that electron density is $7 \times 10^{25}$ $m^{-3}$, the maximum Z reduces to $1.2 \times 10^{-3}$ $K^{-1}$ at around 800 K. PbTe-based compounds can be used in thermoelectric device in a wide temperature range of 300 K to 950 K.

Single phase generation region of Al-Mn-Si-based C54 type compound is vary narrow, and only substitution of 1 at% to Al and Si is permitted. However, due to this slight substitution, electron concentrations changes and n-type and p-type TMs are obtained. The composition of the former is $Al_{32}Mn_{34}Si_{34}$, and the composition of the latter is $Al_{33}Mn_{34}Si_{33}$. Both compounds exhibit a very large absolute value of $S$. exceeding 300 $\mu V/K$. Unfortunately, due to the large electrical resistivity and thermal conductivity, $ZT$. can not obtain as much as expected (NPL 11.)

Also, in the mixed structure of amorphous/nano-size crystals etc (NPL 12,) many termoelectric materials having not large $ZT$. described above but having large $S$. exists.

High transition metal silicide having large transition metal content is very suitable for anisotropic TCE (NPL 13.) Since $S$. is inherently anisotropic and has excellent mechanical properties, it is expected to produce a highly reliable TCEs utilizing anisotropy. The electro-

motive force $ZT_a$. of thermoelectric materials in which $S$. is anisotropic is determined by a difference of $S$. between longitudinal direction and lateral direction (NPL 14) as follows:

{Math. 3}
$$ZT_a = \frac{(S_\parallel - S_\perp)^2 \sigma_\parallel T / \kappa_\parallel}{(1 + \kappa_\perp / \kappa_\parallel)(1 + \sigma_\parallel / \sigma_\perp)}$$

Here, $T_a = (T_H + T_C)/2$., and $T_H$. and $T_C$. represent high and low temperatures of heat source temperatures, respectively. A measured direction of $S$. along a highly symmetrical axis or an orthogonal to that is expressed by symbols $\parallel$. or $\perp$., respectively. An electromotive force$V$.of this type of Thermoelectric-Materials is:

{Math. 4}
$$V = \frac{1}{2}(S_\parallel - S_\perp)\Delta T \frac{L}{D}$$

Here, $\Delta T$. is a temperature difference, $L$. is a distance between contact points of high and low temperature heat source, D. is a thickness of Thermoelectric-Material. Since $\Delta T$. is closely related to the thickness of the Thermoelectric-Materials, an electromotive force sensitivity $V/Q$. is expressed as follows:

{Math. 5}
$$\frac{V}{Q} = \frac{1}{2} \frac{(S_\parallel - S_\perp)}{H \kappa_a}$$

Here, Q. is a thermal flux in the Thermoelectric-Materials, $\kappa_a$. is an average thermal conductivity at an angle of $\alpha$. degrees with respect to a highly symmetrical axis, $H$. is a width of the Thermoelectric-Materials. This equation is effective when a contact resistance is much smaller than a resistance of thermoelectric materials. The main advantage of the Thermoelectric-Materials of this type is no junction at heat sources.

Generation of electric power that takes advantage of electrons moving in space between electrode terminals is thermoionic generation of electricity. The generation utilizes the fact that the electrons from emitter of the electrode terminal at high temperature are emitted by using thermal energy. In the generation, electrons may inhibit the electron emitting from the emitter due to space-charge limited current. To reduce an influence of the space-charge one method avails cesium, and another method uses narrower distance between the terminals than a few micrometers. Cesium being in a plasma state in the space protects from the space-charge limited current and increases difference between values of work functions at both emitter and collector terminals in order to increase electromotive force. In the space, however, the energy of electrons loses due to elastic or non-elastic collisions between the electrons or between the electrons and cesium nucleus.The generation in which distance between terminals is 0.1 mm uses in the universe.

In mechanical alloying process as expressed in PTL 3,ZT of Thermoelectric-Materials is improved by forming polycrystallines of the TMs without changing chemical composition. Improving the above process of using polyvinyl alcohol as a binder, pressing powder of iron silicide and removing a polyvinyl alcohol by heating after pressing, PTL 4 is aimed to reduce production costs by amorphous structure film created by sol-gel process or by dry film fabrication process. According to PTL 5, spark plasma sintering prevents TMs from re-crystallization.

In order to increase ZT of TMs by decreasing thermal conductivity without reducing electric conductivity, according to NPT 15, polycrystalline is formed by hot-pressing after crushing crystal made from BiSbTe into dozens of nanometers in argon. Intermediate structures between amorphous and crystalline are formed in the polycrystalline at low cost so that ZT of polycrystalline has improved from 1 to 1.4. In PTL 6, in order to prevent heat transfer and to allow electric current, the TMs in that heat transfer due to lattice vibration is extremely decreased in TMs having substantially no grain boundary made of glassy solid are contrived in polycrystals made from each grain sizes about or less than 100nm. Using "room temperature impact consolidation" by method of aerosol deposition, the TMs consisting of essentially cage-structured polycrystalline is formed on substrate crystal.

It is decided by potential against WS how WS moves through space between constituents. Near interface of the space, the potential becomes lower due to electric mirror image effect of charge of WS. The potential is obtained by simulation or analytical method like in case of NPL 16.

WS can move into the space from the interface of the s by the fact that WS must go over the potential barrier with thermal energies, electromagnetic energies and/or etc., or tunnel through. In thermionic emission, the emission current amount from the interface are connected to work function by formula of Richardson-Dushman. In case of field emission of electron, the current tunneling through the potential can be also connected with field intensity by formula of Fowler Nordheim, etc. Amount of WS flow discharging from the interface is decided by tunneling probability, thermal energy in the interface and/or electromagnetic waves incident upon the interface, etc. In case of the inter-surface irradiated with laser, the amount of WS flow is decided by intensity of laser irradiation. In the case that current density of WS in the space exceeds $1 \times 10^{10}$ A/m$^2$, amount of electric space-charge due to field emission in the space will become large abruptly, and the amount of WS flow under the space-charge restriction could not increase and then ZT worsens (NPL 17.) The shorter width of the space is, the better efficiency of the Thermoelectric-Materials with the space is improved.

In Thermoelectric-Materials made from the functionally graded materials (FGM) whose electron density due to doping impurities is controlled to continuously change along gradient of the temperature over the working temperature range constructed in Thermoelectric-Materials, the thermoelectric performance of Thermoelectric-Materials can be larger than the figure of merit of Thermoelectric-Material made from uniform constitution. In case of combination of some Thermoelectric-Materials, the concept of thermoelectric performance is different each other according to the intended use. Both metal parts such as electrode and so on of Thermoelectric-Materials and of electric powers also have an influence on the thermoelectric performance. In case that Spaces are formed in Thermoelectric-Materials, by adjusting distances $L_{max}(T)$. between the facing end faces of respective Space (hereafter, the facing end faces of Space are abbreviated as facing end faces), the facing end which is a clue being a mound shape including sharp pointed corner of clue (hereafter, a clue being a mound shape including sharp pointed corner of clue is abbreviated as "sharp pointed corner of clue" for simplicity) and altering a surface size of the steeple tip (hereafter, a surface size of the steeple tip is abbreviated as a surface of the steeple tip, for simplicity) or by changing the shape of the facing end faces, WS can move through Space and the heat transfer without the heat transfer of WS can be reduced.

In case of combining many segmented Thermoelectric-Materials into one with Space and/or Bridging Space, an endurance of thermoelectric systems is determined by fatigues due to thermal stress through temperature distribution at interfaces between Thermoelectric-Materials and electrodes contact with eternal electric powers and/or loads and between segmented

Thermoelectric-Materials, through thermal expansion of Space and Bridging Space and through thermal fluctuations of thermal reservoir during operation due. It has been reported that contact resistances between thermal materials and/or electrodes increase and that as a result burnout due to Joule heat from cracks of the fatigues occurs. Mechanical damages of the thermoelectric systems can be prevented from the thermal expansion by providing Space and/or Bridging Space in Thermoelectric-Material. Because of the width of the space in Space being larger than $L_{max}(T)$, destructions due to quantum fluctuations especially at cryogenic temperature, due to thermal stress at the interfaces through fluctuations of temperature during operation and due to substances except WS moving through the interfaces occurring in operation can be suppressed.

The wider the temperature difference between a high and a low temperature parts, the more the number of Space in Thermoelectric-Material can be. On the other hand, regardless of the temperature difference being wide or narrow ranges, the more the number of Bridging Spaces is, and then the less additional energy losses except the radiational loss can decrease in Thermoelectric-Material.

A nuclear cell is a device as energy of radiation transforms into electric power. It can classify whether or not thermal energy associated with nuclear decay is used. i) The device that uses the thermal energy is thermoelectric conversion system or thermion conversion system. ii) Without using thermal energy, electromotive force is gained by a system in that p-n junction of semiconductor is irradiated by radiation.

In thermoelectric generation using radioisotope, electricity is generated by using the thermal energy generation at that time in either the collection part of the radiation particle beam or decay heat of a portion including a radioactive isotope using a radiation particle beam in the process of natural decay of radioactive isotopes. Inside of TM and TCE or among TM and TCE and good conductor of WS, inventions having benefits described in i) and ii) of paragraph 0019 and paragraph 0020 and in this paragraph exist.

In order to assemble TMs into a module, it is necessary to join themselves each other in some way. Examples of the method of joining are solder bonding method, thermal pulse method (thermal plasma spraying method), physical vapor deposition method, welding process, electroplating method (chemical vapor deposition), pressure contact method, diffusion bonding method, fired ceramic thick film method (joint assembly method), or other joining method or the like. In the solder bonding method diffusion of solder material in use causes degradation. The fired ceramic thick film method often produces physical defects due to oxygen impurities or contamination in joint interfaces. In addition to bondings, a thermal stress generates in bonding interfaces, and then substantially influences durable years of thermoelectric device.

An invention as improvement for better is found in Thermoelectric-Materials and/or both modules and systems made from Thermoelectric-Materials.

In accordance with temperature range and heat transfer amount to be worked, system using Thermoelectric Materials must be optimized by selecting a type, geometrical shape and size of the Thermoelectric Materials, and type and thickness of thermal insulator around them.

For example, in a multi-stairs Π-type module, heat value of an stair Π-type module transfer from two legs of stair module at an upper part of the stair module, that is, upper stair Π-type module absorb the amount of heat from all the legs of the stair module, and a different temperature between them must be occurred, so the legs of the stair Π-type module must have a greater heat absorption capacity than the legs of stair Π-type module. For this reason, multi-stair Π-type module must be conical. Increasing the temperature difference between a top and a bottom of the multi-stairs Π-type module reduces an absorbing heat from the top of the multi-stair Π-type module whole of which is usually kept in a vacuum vessel to remove effects of heat conduction and convection of atmosphere, at low temperature of about -100°C, radiation from surroundings have a great influence to the multi-stairs Π-type module. Parts for an outer wall of Thermoelectric-Material, which are insulations, adiabatic materials, external impact mitigations, radiation shields and the like, must be elaborated. Heat may be radiated by use of air cooling fins, air cooling fins with fan, or water-cooling, and heat exchange with other structures must be also taken into consideration. Thermoelectric-Material is attached to electrodes and structures by grease, adhesive and solder. In order not to occur electrochemical dissolution of solder or not to take place diffusion of grease, adhesive and the like in the modules and the system made from Thermoelectric-Materials described in paragraph 0022 and to prevent from moisture intrusion to the modules and the system, sealing with an epoxy resin, a silicon resin and so on are used. The more heat transfer occurs between low and temperature portions of the module with use of such greases and sealants, the performance of system worsens. Output power of thermoelectric generation $P$ is expressed as:

{Math.6}
$$P = \frac{S^2(T_H - T_C)^2 m}{R(m+1)^2}$$

where, $T_H$ and $T_C$ are respective high and low temperature of heat reservoirs. $m = R_L/R$, here $R$ and $R_L$ are internal resistances and resistance of external load, respectively. Influence of electric contact resistance $R_C$ at junctions between an electrode and Thermoelectric-Material, between different kinds of Thermoelectric-Materials and so forth on module efficiency of thermoelectric generator $\eta$ is expressed as:

{Math. 7}
$$\eta = \eta_C \frac{M - (1+\delta)}{M + (1+\delta)(T_C/T_H)}$$

where

{Math.8}
$$\eta_C = \frac{T_H - T_C}{T_H}$$
$$M = \{1 + Z\frac{(T_H - T_C)}{2}\}^2$$

, and

$$\delta = R_C/R.$$

According to NPL 6, resistance $R_{Bi_2Te_3}$ of $Bi_2Te_3$ alloy, which is thermoelectric device manufactured device $Bi_2Te_3$ manufactured in the form of cross section area A and height H with an electrochemical deposition method on a place where Cu/Ni electrode is metalized on Si/SiO$_2$ substrate, equals $\rho_{Bi_2Te_3}$ $H/A.$, then P is proportional to $H/A.$. Where, $\rho_{Bi_2Te_3}$ is resistivity of Bi$_2$Te$_3$. It has been reported that required cross section of the area decrease and power density increase when $H.$ is made small in nano size from micro size under fixed $H/A.$. As a practical application, $P.$ is about 10 $\mu$W by difference in temperature between a human body and the atmosphere.

Electromotive force of TCE is very low, Π-type module in which a plurality of TCE in a body are connected in series on an insulating ceramic place is often used practically. A deformation module of the Π-type module such as Planer-type module or comb-type module, or a different module from the Π-type module or from the Planer-type module, an integrated module having or not having a fin and the like for receiving/radiating heat on electrodes, which are the electrodes of a pair of TCEs having different polarities and materials possessing both electrodes and structuring materials pressed in series, is also often used. An example of this is a Peltier device which increases energy efficiency. By sandwiching heat absorption fins and radiation fins using also as electrode between a pair of TCEs having different polarities and by providing a heat insulating walls at the boundary between array of these absorption fins and array of these radiation fins, that can bring cold air or warm air.

Possibly, integrated multilayer modules constructed by forming the a pair of TCEs having different polarities into thin sheets, after laminating them alternately and then firing together have the following features:

> i. Electrodes for connecting TCEs are unnecessary.
> ii. A space to ensure insulation between TCE is unnecessary.
> iii. Even when numbers of TCE is increased, it has a high area efficiency.
> iv. Even when a temperature difference is low, it is easy to obtain high electromotive force.

In these way, various modules other than Π-type module have been devised.

The above various invents described paragraph 0021 are applied to module groups of TM or TCE.

Internal resistances and a thermal conductivities of Π-type modules consisting of a pair of differe nt polarities p-type and n-type TCE sandwiched between electrodes depend on the cross section s and the lengths of them. The internal resistance of the module $R_i^{mod}$ and the thermal conductivit y of the module $\kappa^{mod}$ are dependent on the length and the cross sectional area of pair of different polarities. Module figure-of-merit $Z^{mod}$ is:

{Math. 9}

$$z^{mod} = \frac{S^{mod}}{R_i^{mod}\kappa^{mod}}.$$

By improvement of figure factor (cross sectional area / length of a rectangular shape of Thermoelectric-Materials) and the coefficient of performance $\Phi$ ( $= Q_c/P$ at cooling system or$= Q_h/P$ at generating system), making Joule heat generating and energy loss in irreversible process and heat emission release to surroundings which represents $R_i^{mod}\kappa^{mod}$ corresponding to loss by irreversible process, reduce. Where $Q_h$ and $Q_c$ express heat transfer amounts from respective hot and cold reservoirs, and $P$ represents an electric power. And ceramic basis as an insulator is used in some module or is not used in others (skeleton type). Through geometrical size of the basis and temperature difference between the heat reservoirs, the heat stress which arises in a thermoelectric module inserted between hot and cold reservoirs becomes larger in the ceramic basis than the basis of skeleton type. Against the thermal stress generated near intersurfaces in segment heterozygous thermoelectric modules and the like, in which heat reservoir and insulator, insulator and electrode, electrode and Thermoelectric-Materials and several compositions of different heterogeneous Thermoelectric-Materials are piled up in series with parallel to the heat transfer by the best partition of temperature range with respect to ratio of compositions and impurity concentration, a heat-proof improved by betterment for thermal durability cycles against thermal stress generated at the interfaces of the segment Thermoelectric-Materials is put into practice.

Electrodes coated by insulators in contact with heat source and with another different heat sourc e are in a pair. Between these electrodes, system is configured in units of Π-type modules. For example, all many Π-type modules legs having same polarity of TCE are arranged into a parallel circuit in order on a coated electrode in order to increase output current in generation of electric p ower. On the other hand, neighboring pair of Π-type modules are turned upside down each other and series arrangement located up and down and the neighboring pairs having different polarity of TCE are attached on each coated electrode into a series circuit in order to increase output volt age, and composite arrangement of above configurations are present. Thus many Π-type modul es are assembled from heat reservoir, electrodes, and different polarities of Thermoelectric-Mater ials. In order to improve efficiency of those Π-type modules, figure of merit of TCE must be chan ged. In such case, cross sectional areas and lengths of TMs in Π-type modules may differ from e ach other. In systems for thermoelectric generation of electricity whose parts acquire heat transf er amount $Q_{in}$ from a certain heat source, the parts give heat value of $Q_{in}$ to thermoelectric module s, and the heat value flowing in TMs is emitted to another heat source with the heat value $Q_{out}$. F or these duration an electrical power $P$ obtained acts to external parts. Thus, the balance (or equil ibrium) between incomings and outgoings of energy is maintained as:

$$\pm P = Q_{\text{in}} - Q_{\text{out}}.$$

(+ represents the case of power generation by the Seebeck effect, - represents the case of cooling system by the Peltier effect) The system performance $\eta$ is:

{Math. 11}

$$\eta = \frac{P}{Q_{\text{in}}} = 1 - \frac{Q_{\text{out}}}{Q_{\text{in}}}.$$

To maximize $\eta$. the following is taken into account,

1) To balance the target performance and ability of the module to be used.
2) To maximize performance of a single module somewhat economically.

For example, system efficiency of power generation $\eta_{gen}$ is

{Math.12}

$$\eta_{gen} = 1 - \frac{Q_A}{Q_C}.$$

Using the ratio $m = R_0 / R_i^{MOD}$ of an external resistance $R_0$ fitting for an external work to an internal resistance $R_i^{MOD}$ of module, m must be optimized so as to maximize $\eta_{gen}$. It is known that maximu m efficiency $\eta_{gen}$ is determined only by temperature conditions and physical properties i.e. figure-of-merit of TCE. On the other hand, cooling system efficiency $\eta_{re}$ is expressed as

{Math.13}

$$\eta_{gen} = 1 - \frac{Q_C}{Q_A}$$

m must be optimized so as to maximize $\eta_{re}$. As a result, WS flow into $R_0$ is minimized, and then P is minimized.
Optimization of this paragraph is applied to module groups or a system made from TMs and/or TCEs.
Furthermore, since over a wide range of temperature any TMs and TCEs are not in good characteristics of power generation, in case of high temperature exceeding several hundred degrees, cascade-type thermoelectric module laminating several types of TMs have been produced, development of applications in range up to about 600°C is performed. A thermoelectric conversion efficiency of these module becomes high as temperature or temperature difference of these module is large (NPL 19.) The modules or system can be composed by TM and/or TCE by use of the above contriving improvement.
Commercially available thermoelectric module is covered with outer walls of ceramic plate or the like in order to be used generally. Upon applying instrumentations made of these to general uses, apparatus are combined with fins for heat receiving and/or dissipation under pressure, heat resistance of the instrumentations gradually increases. For this reason, for available temperature difference between heat sources, the heat resistance no more contribute to power generation, efficiency of these is reduced. In general, conversion efficiency of the instrumentation reduces to nearly half of that for the module.
Conversion efficiency of TM is not always sufficient, in regard to resolutions of problem about reducing the conversion efficiency of instrumentation it is more effective when heat sources of the instrumentation are in relatively high temperature. Although outer parts of instrumentation are pressed firmly to low temperature heat source with use of ceramic plate, electrodes of instrumentation are not contact with but exposed directly to high temperature conversion methods (NPL 20) by direct delivery and receipt of heat between the high temperature heat sources and the electrodes of instrumentation are found. Since the hot side ceramic plates and heat collecting system are omitted, the heat resistance loss to these is reduced, furthermore a high temperature difference can be added to the Thermoelectric-Materials, and then it is a significant improvement in the thermoelectric conversion. Conversion efficiency of two-stairs cascade module made of Π-type modules becomes 83% of that of previous modules. Further, since the high-temperature part of the module is released from pressure contact forces and is cantilever structure, the thermal stress distortion problem caused by the temperature difference which has been regarded as a conventional problem is also reduced, versatility in installation has expanded, and reliability of this is improved. Because of cantilever structures, moreover, the module hot sections are opened from the contact pressure, thermal stress-strain problems caused by the temperature difference which have been the conventional problems are also alleviated, and improved expansion and reliability of versatility in setting up instrumentation increase.

Citation List

Patent Literature

{PTL 1}　Japanese Patent Application No. 2011-57202 JP
{PTL 2}　WO201430264A1
{PTL 3}　Patent H9-55542 JP
{PTL 4}　Patent H10-27927 JP
{PTL 5}　Patent H10-41554 JP
{PTL 6}　Patent 2007-246326 JP

**Non Patent Literature**

{NPL 1}   K. Kuroki, R.Arita, J. Phys. Soc. Jpn, Vol. 76 (2007) 083707.

{NPL 2}   Junichi Takahashi, Scientific Research Grant Program (Grant-in-Aid for Scientific Research) Research Report Form C-19, 2012. May 18 {NPL 2} Naooki Yamada, Satoshi Taga, comprehensive engineering Vol. 24 (2012) 10-16

{NPL 3}   Kamran Behnia, et al., Phys. Rev. Lett. 98, 076603 (2007)

{NPL 4}   Phys. Rev. Lett., 958 , 166602 (2007)

{NPL 5}   Science, 317 1729 (2007)

{NPL 6}   Ryoen Shirasaki: "Fundamental Relation Between Transport Coefficients in Quantum Hall System", Yukawa International Seminars 2007. (200711229) Kyoto International Conference Hall.It is already stated in Japanese Patent Application No. 2011-67202 and WO20143264A1, so it can be omitted?

{NPL 7}   Yuya sakuraba, Kota Hasegawa, Masaki Mizuguchi, Takahide Kubota, Shigemi Mizukami, Terunobu Miyazaki and Koki Takanashi, "Anomalous Nernst Effect in an L10-FePt/MnGa Thermopiles for New Thermoelectric Applications", Applied Physics Express, Vol. 6, p. 033003 (4 pages) (2013)

{NPL 8}   Phys. Rev. B 47, (1993) 16631

{NPL 9}   Jpn. J. Appl. Phys. 47 (2008) 2005

{NPL 10}   M. Akasakaa , T. Iida, T. Nemoto, J. Soga, J. Sato, K. Makino, M. Fukano, Y. Takanashi, Journal of Crystal Growth 304 (2007) 196-201.

{NPL 11}   Toyama, A. Yamamoto, H. Hazama and R. Asahi: Mater. Trans. 51 (2010) 1127-1135.

{NPL 12}   T. J. Zhu, F. Yan, X. B. Zhao, S. N. Zhang, Y. Chen and S. H. Yang: J. Phys. D: Appl. Phys. 40 (2007) 6094-6097.

{NPL 13}   Isoda, Y.; Nagai, T.; Fujiu, H.; Imai, Y.; Shinohara Y., Proceeding of ICT' 07 2008, IEEE, pp251.

{NPL 14}   Fedorov, M. I.; Zaitsev, V. K. Thermoelectrics Handbook. Macro to Nano; Rowe, D. M.,Ed.; CRC press. Taylor & Francis group, Boca Raton-London-New York, 2006; pp 31-1-31-19.

{NPL 15}   Poudel, B. et al.,"High-Thermoelectric Performance of Nanostructured Bismuth Antimony Telluride Bulk Alloys," Science, vol.320, no.5876, pp.634-638, May 2008.

{NPL 16}   Jpn.J. Appl. Phys. 48, 098006(2009)

{NPL 17}   Appl. Phys. 33, 2917(1962)

{NPL 18}   J.-P.Fleurial, G.J.Snyder, J.A.Herman, P.H.Giauque, W.M.Phillips, M.A.Ryan, P.Shakkottai, E.A.Kolawa and M.A.Nicolet: 18th International Conference on Thermoelectrics (1999).

{NPL 19}   Foundation Engineering Advancement Association: Development of the Cascade module (high-temperature region Co-Sb-based, low-temperature range Bi-Te-based material) thermoelectric generator forum lecture Book October 2005

{NPL 20}   Ota Minoru: Development Japan Thermoelectric Society of highly efficient thermoelectric conversion system magazine, Vol.4, No. 4, October 2007, pp. 15-17

**Summary of Invention**

**Technical Problem**

Thermoelectric-Materials as a target is a composite functional material having a large thermoelectric power, low electrical resistivity and thermal conductivity together. In the improvement by material exploration of the TMs, it is indispensable to precisely measure these three parameters. Thermoelectric-Materials and module including these Thermoelectric-Materials cannot be scan by the method of "digital" screening as transition temperatures of superconducting materials or ferromagnetic materials. Instead of making the improvement by the material exploration of Thermoelectric-Materials, using PTL 1 and 2,

1) in classical, quantum or macroscopic quantum systems, controls of inter-terminal distance in Space_between facing terminals,

2) in Space of TCE and Bridging Space being in the space part of Space cross-linked with a fine structure, by WS flow control by use of electromagnetic fields and/or radiations outside system made from Thermoelectric-Materials,

3) to allow power generation, cooling or heating operation control in modules and system made from TMs and TCEs,

4) in order to avoid damages due to charges and/or heat retention either by light outside of system or by radiations by the radiation sources and the like inside of system, by use of TM and TCE, good conductor of WS and the like,

5) $\Pi$-type module made from a pair of different polarity TCE and insulations, further $\Pi$-type module group consisting of combination in mixture of series and/or parallel or those mixture of TCEs other then the $\Pi$-type module (hereafter, abbreviated as "module groups consisting of combination of TCE") in "module groups consisting of combination of TCE",

6) to avoid damages due to the charges and heat retention, insulators, TMs, TCEs and so on as not to cause large disturbances of WS flow and/or heat flow, and in such manner, "module groups consisting of combination of TCE" are fabricated. The TM not applying devices of PTL 1 and 2 is defined as 0th generation Thermoelectric-Material, then the above "module groups consisting of combination of TCE" corresponds to 1st generation Thermoelectric-Material, but

7) through the above described 1)-4) that is the process of the 0th generation thermoelectric conversion element constructing from a 0th generation Thermoelectric-Material by using the devices of PTL 1 and 2, moreover as radiation energy loss of Spaces of the 1st generation Thermoelectric-Material is less, a 1st generation thermoelectric conversion element must be fabricated,

8) a fabricated material made from the 1st generation thermoelectric conversion element as well as 0th generation Thermoelectric-Material, i.e. the 1st generation thermoelectric conversion element by use of the above 5) and 6) processes become the 1st generation Thermoelectric-Material because of including the fabricated material, and a 2nd generation thermoelectric conversion element constructing from the 1st generation Thermoelectric-Material by using the devices of PTL 1 and 2 is obtained, and then a 2nd generation Thermoelectric-Material as before, furthermore these processes carrying on in succession make a thermoelectric conversion efficiency of an obtained thermoelectric conversion system nearly the Carnot efficiency.

9) So far a basic system in which one of two different heat source temperatures does or does not coincide with the ambient atmosphere is dealt with. In two or more different heat source temperature, to manufacture an $i$ th thermoelectric conversion system nearly the Carnot efficiency combined with $i$ th basic system ($i$ = 1,2, ..., *natural number* the basic system corresponds to $i$ = 1) is an object

## Solution to problem

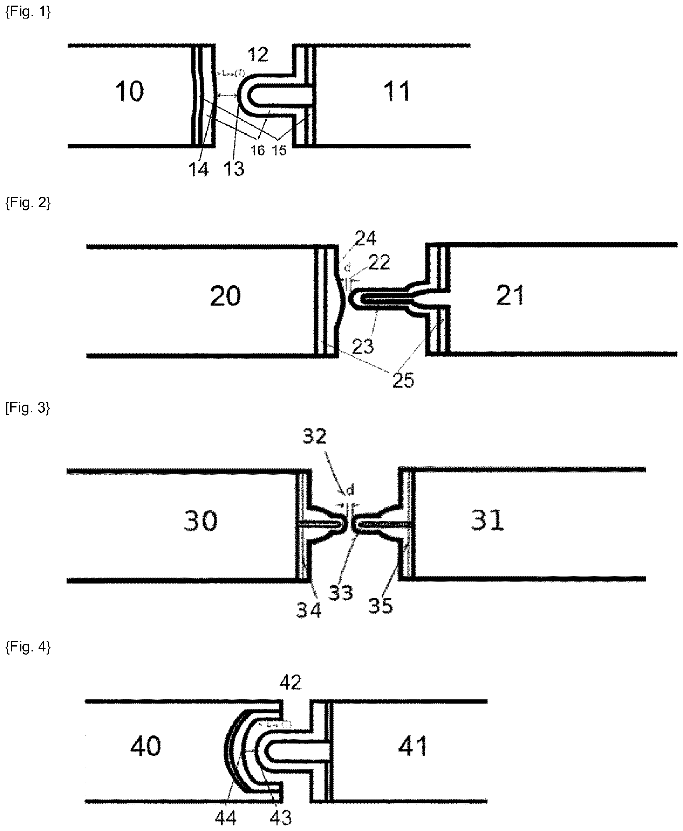

As shown in Fig. 1, Space 12 of sub-micron meter width is arranged (hereafter, abbreviated as between the Material 10 and 11, for simplicity) so as to prevent heat transfer in a direction of the heat transfer and WS flow stream. A characteristic feature of the claim 1 is that the amount of WS flow in 12 is almost equal to or maintaining higher than those in 10 and 11 of two left and right, and, however, reducing the heat transfer caused by quasi-particle such as lattice vibration, magnon, or spin wave and the like, thermal fluctuation of heat source or between Space and neighboring materials, quantum fluctuations at low temperatures and macroscopic-quantum fluctuations make efficiency of thermoelectric system improve. Between the terminals of the Thermoelectric-Materials 10 and 11 in Space 12 in Fig.1, a distance from a steeple tip whose leg is set on top of a mount shape or is thick in accordance with any shape of inter-surface for 16 on 11, to its confronting terminal surface 14 is described as "distance" $L_{max}(T)$ being dependent

on the absolute temperature $T$ at the surface 13. In case that the distance is larger than $L_{max}(T)$, the heat transfer amount by phonons and the like becomes almost negligible through Space 12. In addition, $L_{max}(T)$ due to a spin wave or magnon and so on is much smaller than that due to lattice vibrations. $L_{max}(T)$ can be estimated from some actual measuring range of the measurement surface distance and atomic force microscopy. On the other hand, Space 12, whose width is smaller than sub-micron meter makes it possible to avoid being limited to the space-charge restriction of WS. By making the width of Space 12 close to $L_{max}(T)$ from sub-micron meter, Space 12 to increase the amount of WS flow through Space 12 can be produced. In during operation, a thermal energy transfer due to radiation energy loss in Space 12 depends on the temperature difference between 13 and 14 and the facing ends to each other in Space 12. In case that the distance between 13 and 14 terminals is wider than $L_{max}(T)$, but narrower than the sub-micron meter, the radiation energy loss in Space 12 is negligibly small because that the temperature difference between either facing ends of Thermoelectric-Materials or facing ends of Thermoelectric-Materials and electrodes to each other in Space 12 is the order of a few Kelvin temperature. Moreover, by Space 12 being in a vacuum, it is suppressed the heat transfer by convection there. The thermal conductivity of metal is mostly due to thermal conductivity $\kappa_c$ of classical WSs, in case of semiconductors, however, heat conducting component $\kappa_{ph}$ due to lattice becomes larger. By utilizing the difference of the factors for the physical transmission phenomenon for $\kappa_c$ and $\kappa_{ph}$ in Space, it is the device that the value of $\kappa_{ph}$ is zero and that of $\kappa_c$ is reduced. In case that $\kappa_{ph}$. component is as same order as $\kappa_c$. component, that heat transfer caused by phonon is suppressed, and that other parameter is not to change, the figure-of-merit in Math. 1 will be easily twice as large as that of unsuppressed. In some Thermoelectric-Materials having large figure-of-merit, amount of $\kappa_{ph}$. is as large as that of $\kappa_c$..

A steeple whose surface faces "sharp pointed corner of clue" in Space is made. The steeple leg, which is set on top of a mount shape, is thick in accordance with any shapes of inter-surface for terminal of either a Thermoelectric-Material or good conductor of WS. Fig. 2 is an example in which the steeple leg is thickened to release WS.

Fig.3 is a case where two steeples confronted each other are spire structure of nanometer order and where the width between two surfaces of steeple tips confronted each other is sub-micron meter or less of the order. That structure is an excellent one to the control of WS flow at the emitting and receiving portions of WS.

Accompanying drawings, which are incorporated in the present description and are parts of constructions for the description, schematically illustrate one or more practicable examples according to principle of the present invention. In the drawings of general idea for the principle the essence of this description is emphasized.

In case that TCE including WS could be or be not supplied with current or voltage applied from "end plates for connecting with system of the external world", in either way Space is applied with the voltage, if the height of the steeple is high and/or the distance between the surface of "sharp pointed corner" 14 and the steeple tip 13 is closer to $L_{max}(T)$ from wider width than $L_{max}(T)$., or radii of curvature for protective members 16 in Fig. 1 covering "sharp point corner" with protective member 14 and the steeple tip 13 are smaller, than magnitude of electric field applying WS increases, and then the height and the width of the potential barrier of WS in the neighborhood of protective members 16 are greatly reduced. The maximum electric field $E_{convex}$., which occurs at convex end surface of steeple 13, is described as $E_{convex} = \beta E_s$. by use of the enhance factor $\beta$. depending on the height from the joint surface between the Thermoelectric-Material 11 and the steeple leg and on the radius of curvature at the convex for tip of the steeple 13 covered with protective member 16. Here, $E_s$ is an electric field near flat plate that corresponds to WS release surface 13 in TCE being a flat plate. In order for WS to tunnel through Space 12, the value of $E_s$. must be greater than $10^9$ [V/m]. The electric field at tip of the steeple 13 covered with protective member 16 can be increase in case that the radii of curvature at both the surface of "sharp pointed corner of clue" 14 and the convex for tip of the steeple 13 covered with protective member 16 are smaller, that the height is taller and that the distance between the surface of "sharp pointed corner of clue" 14 and the steeple tip 13 is shorter. Current in the steeple is dependent of the electric field and on WS release area at the convex end surface of steeple 13, by WS release methods which are not only dependent on a variety of WS, but also WS release using thermal energy, field emission of WS, WS emission due to light and the like and/or according to the space-charge restriction of WS the current flows through 12.

In case that WS having either positive or negative polarity of charge or WSs having two kinds of polarity such as different positive and negative charges move in thermionic material in TCE, further temperature gradient, WS concentration gradient, WS velocity gradient and the like can bring about by an electric, a magnetic source and/or the like temperature are arrange outside of TCE. These gradient make a respective remarkable operation for classical WS, quantum WS and macroscopic quantum WS different. In addition spatial dimension of those Thermoelectric-Materials system restricts the quantum WS and the macroscopic quantum WS in their movement, one of the movements separates the degree of freedom for charge and spin. It is possible to add electromagnetic fields individual steeples and so on. By the method in which magnetic fields are added perpendicular to a plane which is set by two adjacent steeples in each of which either positive and negative WS charges flows, directions of WS flow and thermal flow can be divided each other. The effects of these electromagnetic fields appear through WS moving in the steeple or the two adjacent steeples in Space 12. Further, probability of the tunneling quantum WS exponentially decreases as the mass for macroscopic quantum WS increases. By utilizing the fact that the probability of the tunneling potential barrier for macroscopic quantum WS exponentially decrease, a sensor fabrication to find very small changes is possibly made.

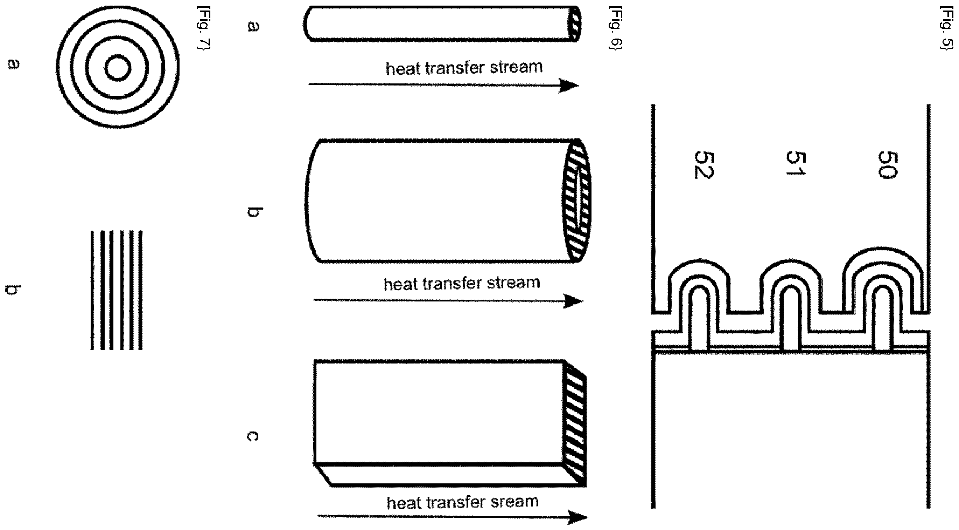

By the voltage applied to Space 12 in Fig. 1, if the strength of obtained electric field near 13 can not be increased to the required value, then I) the height of the steeple is high and the distance b etween the surface in contact with the steeple leg and surface facing with the surface is wider. O r ii) an amount of WS is small, In the above I) the strength of obtained electric field near 13 being increase to the required value due to the paragraph 0025, and by the height of the steeple is low er, the radiation energy loss can be decreased. Or by the $\Pi$-type module described in the paragr aph 0025 even if the height of the steeple is higher than micrometers, the distance between the s urface facing with the steeple makes smaller than micrometers. And then the radiation energy lo ss can be decreased. In the above ii) as in Fig. 4, by deforming the shape of WS that is charged particle receive surface 44 so as to the surround charged particle emission tip 43, the area in whi ch the electric field is the maximum electric field $E_{convex}$ increases than that prior to the deformatio n and area for thus enhanced portion of charged particle emission increases. And more the elect ric field at pointed parts of WS receive surface 44 could bring about to be in maximum. In case o f WS flow being small through a single steeple, thermoelectric materials whose Seebeck coefficie nt is very large are usually used, but as shown in Fig. 5, many hollows 50, 51 and 52 whose surf aces are in parallel to respective surfaces of the steeple tips each other improve to increase the fl ow than WS flow in the steeple. In that case, each temperature of 50, 51 and 52 should be in sa me temperature.

In Fig. 1 values of potential and kinetic energies of WS differs from each other according to WS moving through Space 12 in Fig. 1, in the ether Thermoelectric-Materials or conductor i.e. 10 and 11, in the surface of the steeple tip13 or in the "sharp pointed corner of clue" 14. And it is a possibility that the kind of WS itself may change into other WSs. In the case that WS moves in the direction from 11 to 10, WS emitted from the surface 13 of the steeple tip takes heat from the Thermoelectric-Material 11. On the other hand, WS moves through Space 12 and reaches the WSs receive terminal i.e. the "sharp pointed corner of clue" 14, then the difference of WS between the highest energy of WS occupied energy levels in the steeple and an energy for WS occupying one of WS unoccupied conduction energy levels in the WSs receive terminal 14 is released as energies such as heat and so on in the Thermoelectric-Material or WS good conductor. Using the heat generated during this WSs receive terminal, it is possible to increase electromotive force of the Thermoelectric-Material 10 using the thermal energy generated during above process.

In the case that WS moving through Space 12 of Fig. 1 has passed through the WSs receive terminal i.e. the "sharp pointed corner of clue" 14 and is going to pass the surface of either the Thermoelectric-Material or electrode made of WS good conduction material 10 or pass the surface of the steeple 13, the energy of WS is dissipated to surface states of WS near the terminal and the surfaces by tunnel friction at the tunnel penetration through the terminal and the surfaces so that the amount of WS concentration conducting through these materials increases and then the amount of WS flow also increases. On the other hand, WS moving through these materials or through Space in these materials has momentum parallel to the direction of WS flow stream. It is possible to increase the amount of WS flow further by the use of this momentum parallel to the direction of WS flow stream. Due to WS increased momentum the amount of WS flow in TCE according to the claim can be large.

In case that WS working passes through interterminal distance of Space either between the surface of "either the steeple tip (or clue) or the steeple" and its facing either terminal or clue, or between facing clues, temperature limits of WS working in either classical in some TMs or quantum system in other TMs are determined and those of WS working in macroscopic-quantum system being in facing materials which are placed apart each other at inter-terminal distance are also determined in each material. Than the value of $ZT$ which is determined from TM used in wide or all over temperature limits which range from those of the classical system either to those of the quantum system or to those of quantum system and the macroscopic-quantum system, the wide or all over temperature limits are disjointed into some temperature limits for each segmented Thermoelectric-Material in which respective each Thermoelectric-Material being in the highest value of $ZT$, the value of $ZT$ for the Thermoelectric-Material in case of combining many segmented Thermoelectric-Materials into one in improved. The value of $ZT$ for the segmented Thermoelectric-Material in case of combining many Thermoelectric-Materials into one as TCEs with Space is further improved than that of $ZT$ for the segmented TM without Space. And Space, moreover, makes damages due to thermal stress and/or diffusion mixing of matter, solder material and the like in use decrease. Due to WSs passing through the above described facing surfaces in Space made from Thermoelectric-Material and so on, emission and/or absorption thermal energies, distribution of WS momentum parallel to the direction of WS flow stream and/or variation of spin distribution in the facing surfaces can be utilized.

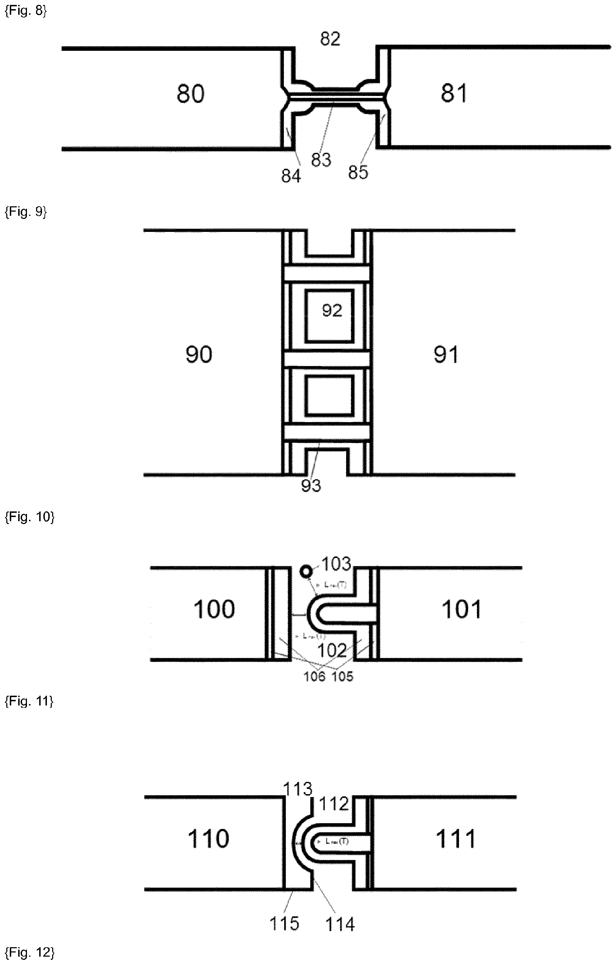

Claim 1 is connected with TCE having Space between the facing the steeple tip (or clue) 13 and the steeple 14 in Fig. 1. By use of the above mentioned method, it is difficult for WS to pass through Space, amount of WS flow passing through Space could be occur to be less than those of WS flows in either Thermoelectric-Materials or Thermoelectric-Material and WS good conductor which sandwich Space. In that case, by Bridging Space 82 with bridging materials whose each leg, connected with either the Thermoelectric-Materials or the Thermoelectric-Material and WS good conductor 80 and 81, can be thick in accordance with any shapes of intersurface for terminal of either a Thermoelectric-Material or a good conductor of WS and by suppressing heat flow due to direct lattice vibration from the terminal of 81 to that of 80 using the bridging material whose length is longer than $L_{max}(T)$, the amount of WS flow through Bridging Space can be much more than that of Space. As 83 in Fig. 8, and furthermore effect of the lattice vibration through Bridging Space a columnar with a diameter of several nanometer (Fig. 8b), or, at least, a "plane" in which one side of the vertical plane to the direction of WS stream is a length of several nanometers (Fig. 8c) is much more remarkable than that of the lattice vibration for surfaces which are not the cross sections of them. And in this case WS is not scattered except the direction of WS flow stream, the amount of WS flow is large if the area of "plane" dose not influence the scattering WS along the direction of WS flow stream. WS flow is subject to the influence of the special dimension as shown in Fig. 6. In the case that the amount of WS flow in a bridging material is smaller than those in either Thermoelectric-Materials or Thermoelectric-Material and WS good conductor which sandwich the bridging material, cross sectional area of the bridging material made from a conductor for WS are enlarged, otherwise number of the fine structures which are made from a conductor for WS is increased. In the hollow cylindrical shape and the flat board of the wall thickness of a few nanometers (Fig 6b and c), the amount of WS flow is less than that in the column (Fig.6a), but is better than that in the bulk in spatial three dimension. It is characteristic for the claim 2 that the thermoelectric performance of TCE is increased by the fact that Bridging Space, in which cross-linked with fine structures across Space 82 between either Thermoelectric-Materials or Thermoelectric-Material and WS good conductor 80 and 81 as shown in Fig. 8 is included in TCE.

The amount of WS flow, through the Thermoelectric-Materials or the structures made of either combination of the column in Fig. 6a and the hollow cylindrical shape in Fig. 6b or combination of flat boards in Fig. 6c whose cross sectional views of Fig. 7a are for the former and that of Fig. 7b for the latter, is not smaller and more over the combinational cross section must be large not to be less than that of WS flow through the Thermoelectric-Material without the fine pillar structure as shown in Fig.8. Hereafter, this type of the bridging structure in Bridging Space is abbreviated as Fine Structure, for simplicity. The figure of merit in Math. 1 can enlarge through increase of phonon scattering on the interfaces of the layered structures in Fine Structure in which a mobility of WS is high. In addition, through portions, to which portions for high mobility of WS are adjacent, made from materials for low mobility of WS having a thickness in which WS is not transmitted in a radial direction, the amount of WS flow through Fine Structure over all increases so that it is possible to increase the value for the figure of merit derived from Math. 1, In case of length of Fine Structure 83 being short, phonon motion is in ballistical one so that the thermal conductivity of Fine Structure is high, and then the figure of merit decreases. In case of the length 83 being long, keeping in mind so as not radiation energy loss increases and then it is possible by using Fine Structure made from Thermoelectric-Materials to increase not only the electromotive force generated in Fine Structure but also the figure of merit enlarge by the generated electromotive force therein.

In the case that the length of Fine Structure is longer than that of the mean free path of phonon, the thermal conduction obeys Fourier's law. The length is shorter, the phonon motion becomes more ballistic one that makes thermal conduction increase so that the thermoelectric performance of TCE including Fine Structure is worse. In Fig.8 in the interfaces between Fine Structure 83 and either 80 or 81, without Bridging Space as large as possible. In order for the amount of WS flow through Fine Structure to surpass those of the Thermoelectric-Materials, many bridging materials of Fine Structure are introduced in Space as shown in Fig. 9.

Electric current is carried by the classical WSs, quantum WSs and macroscopic quantum WSs. Heat is transferred round by incidents accompanied with WSs causing electric power, by lattice vibrations, by radiation and so on. In the case that the width of Space is narrow, or that Space is bridged across by the fine structure, the quantum WS can be utilized at cryogenic temperatures. Hereafter, for simplicity, the space bridged across by the fine structure is abbreviated as Bridging Space as before. In case of magnetic field applying to Thermoelectric-Materials, and the resistance of WS applying to WS flow stream, directions of heat transfer and electric current and that of gradient of voltage are not in the same direction by Hall effect and Nernst effect. A width of Bridging Space for lattice vibration being larger than $L_{max}(T)$, and Bridging Space and Space established to prevent heat transfer except for the heat accompanied with WS flow make the thermoelectric performance of TCE improve.

In the case that the terminal of the Thermoelectric-Material 101 facing and in contact with Space 102 in Fig. 10 is irradiated by electromagnetic field including light and radiation, those energies are applied to WS. And WS becomes in higher surface energy states, then the energy that WS goes over the potential barrier of WS into Space 102 decreases. In the latter, the width of the potential barrier which WS tunnels through, moreover is reduced. Otherwise WS in the terminals of Thermoelectric-Materials can take in energy states of WS easily running away from the terminals of the Thermoelectric-Materials. Radiation serves to mainly help the movement of WS from the terminal releasing WS to the terminal receiving WS. Claim 3 represents that energies from the sources of electromagnetic fields and of radiation arranged in 102 in Fig. 10 supply to WS moving through Space 102, WS getting away in Space 102 from the terminal releasing WS and the terminal of the material 101 from which WS releases so that WS can conduct easily through Space 102. The radiation sources can also be embedded in the terminal of 101 of the materials and/or the terminal of 100 facing the terminal of 101 from which WS releases. In the case that the radiation sources are either placed in the vicinity of or embedded in 105 and 106 covering 101 contact with steeple and/or the steeple leg, it is possible to utilize the heat by radiative decay. In case of using light, WS emitting surface can be irradiated by the light guided into 102 through glass fiber. Otherwise, it is able to reach light at the terminal near the center of 102 by enlarging larger the distance between the outside ends of confronting terminals in Space 102. It is also possible to include the effect of field emission by the steeple built on the terminal 101 in Fig.10.

Diffusion solid atoms decreases due to Space12 in Fig. 1, at especially high temperature mutual solid atomic diffusion cross the interfaces between the Thermoelectric-Materials and/or electrode is reduced and, moreover, the internal resistance $R_i$ in TCE also decreases and life of durability for TCE is improved. As in the cooling operation, value of $R_i$ in TCE can be reduced, so that the reduction of $R_i$ not only can decrease endothermic amount, but also can decrease the amount of absorption energy by $R_i(I_{ac})^2/2$. If the current of WS contains a component of alternate current part $I_{ac}$, the thermoelectric performance of TCE is improved more at the same power supply with the same ripple ratio, which is the ratio of AC component to DC power supply.

In TCE including Space and/or Bridging Space, the mobility of WS is not uniform with respect to location and time of WS motion. At an interface where inflow and outflow of charge possessed by WS is different from each other, the either outflow or inflow charges possessed by WS at the interface is much accumulated and the accumulated charge prevents WS from moving through the interface. And WS having charges stores up at the interface, then deterioration of TCE occurs. By the method that "sharp pointed corner of clue" on the terminal receiving WS is covered with WS good conductive coating and/or a thick member 15, the amount of WS flow can increase and be uniform. WS good conductive coating and/or a thick member on the terminal releasing WS could be removed. Claim 4 is characteristic of getting the effect that the locally stored charges are diffused by coating the surface receiving WS and/or the surface of the steeple with good conductors for WS.

Protective member 16 eliminates the damages at the point where radiation source is set and radiation irradiates, and due to heat energies by radiation decay at the radiation source and at the point irradiated by radiation decay, it is possible to except an increase in WS flow by tunnel through or by over the potential barriers. The roughness of the terminal releasing and/or receiving WS covered with the protective member is suppressed, it is possible to improve the quality of TCE by less scattering WS at these terminals.

The coating of the thin films of good conductors strengthens the quality of TCE or reduces less degradation due to preventing from concentration of heat on the surface and the amount of energy obtained per unit time is increased. By coating the surface of "sharp pointed corner of clue" accepting or that of the steeple tip releasing WS with the good conductors, the potential barriers for WS moving from the terminal to the other Thermoelectric-Material, which is based on WS concentration difference between the surface of "sharp pointed corner of clue" receiving or and that of the steeple tip releasing WS or between each terminal and its respective inner part of Thermoelectric-Material, decrease or the fracture of TCE based on shortage or excess of WS concentration is reduced.

In case of TCE having Space, local impingement and mechanical destructions due to WS moving across Space make the deterioration of the terminals or the surfaces take place. Further, by enc apsulating the metal vapor or gas in Space 12, and the energy state of WS changes due to collisi ons between WS and the atom and/or molecule, or by the collision between WS in Space 12. Cl aim 5 is characteristic of coating or uniting the surfaces, which are the surface of the steeple tip h aving WS 13 releasing from the steeple tip or that of "sharp pointed corner of clue" receiving WS 14, with other materials whose forces between their constitutional atoms are stronger than those of the uncoating or ununiting surface or in which cooperative motions occurs in order to eliminate the Thermoelectric-Material failure except friction in the surfaces which WS has tunneled throug h or received. Alternatively it is possible to prevent deterioration of TCE by absorbing vibration w here the cage-structured compounds is used in "sharp pointed corner of clue" receiving WS 14. For example, WS good conductive coating materials can be realized in materials mainly including C$sp^2$.of a variety of hybrid ratio in C$sp^2$.,C$sp^3$. and the like, the other atoms and/or molecules and s o on and a big binding force between atoms in high insulating materials can do in materials mainl y including C$sp^3$. of those.

Due to the functionally graded materials (FGM) by use of Space or Bridging Space, claim 6 is characteristic of power generation, cooling or heating operation system configuration which is changed as same as the system creation by conjugation both with the absence of defects in the device creation by conjugation and with the influence of performance degradation due to the diffusion of the components of the electrode material or a Thermoelectric-Material being small. As shown in Fig. 11 the distance between the surface releasing and the surface accepting WS can be changed the gap distance.

For power generation of Thermoelectric-Materials in the wide temperature difference between the hot and the cold parts, the electromotive force can be increased by the method of constituting many Spaces in TCE. As shown in Fig. 12, TCE is composed of many segmented Thermoelectric-Materials and/or Conductors. In this case, as mentioned in paragraph 0047 both heights of nano meter sized pillar (i.e. steeple) or coils made of TMs and/or Conductors formed on the terminal 121 in TCE and the radii of curvature of the nano meter sized structures of the surfaces releasing WS have influence on deformation from bulk density of states for WS in Thermoelectric-Materials and/or Conductors on WS transforming in Thermoelectric-Materials and/or Conductors including Spaces, but these heights and the radii of curvature, the areas of the surfaces for the steeple releasing WS such as the tip of the nano meter sized pillar and coil structures including the side of the coil, the optimum distance between the surface releasing WS for one of amoung the steeple and the coil structures and the like and surface receiving WS for "sharp pointed corner of clue" facing with the steeple and/or the optimum number of Space are determined as follows. By approach from sub-micro meter and larger than $L_{max}(T)$ to $L_{max}(T)$ the width of distance between the ends of Space is decreased, as in concrete expression of the power generation operation in Fig. 12, the amount of WS flow in Space more increases as in the following,

1) In the case that the distance between the surface of the steeple and its facing either the (i.e. "sharp pointed corner of clue") or a terminal in Space is larger than $L_{max}(T)$, the thermal transfer by use of phonon can be negligible small in Space. As mentioned in the paragraph 0035, $L_{max}(T)$ has relation to the force between atoms constituting the surface of the steeple and its facing the steeple tip, and is determined from the actual measuring range of distance between the atoms of needle of atomic force microscope which are ones of the above surface and its target surface which are ones of the steeple tip. $L_{max}(T)$ can be compensated by taking account of thermal expansion, fluctuation of thermal source and quantum fluctuation especially in cryogenic temperature.

2) During operation, an enhanced electric field near convex surface of either (i.e. "sharp pointed corner of clue") or the steeple in Space is approximated the electric potential difference divided by the distance between the surface of either the steeple tip or the steeple and its facing terminal by multiplying the enhancement factor β, which is the height of either the steeple tip (i.e. "sharp pointed corner of clue") or the steeple divided by the radii of curvature of the surface. Otherwise, the enhanced electric field is determined by numerical simulation. The difference of the electric potentials between the surface and its facing terminal is also affected by electromotive force yielded by the Thermoelectric-Materials and/or Conductors on either side of Space.

3) The amount of WS flow through Space due to thermal excitation of WS, quantum fluctuations in cryogenic temperature and tunneling, depends on WS emission area and the direction of WS flow stream. And as mentioned in the paragraph 0008 , in the surface of the steeple tip where WS is injected and in "sharp pointed corner of clue" facing with the surface of the steeple tip, the bulk density of states for WS in TM through the surface of the steeple tip depending on the direction of momentum for WS flow stream changes from pre-infusion, so that the changes for the density of states have influences on microscopic electric and thermal conductivities. In the case that the section between "sharp pointed corner of clue" facing with the surface of the steeple tip and the terminal on which the surface of the steeple tip stand exchanged by the thin fine or the pillar-structures with diameter in a few nanao meters, the changes for physical character of the structures improves the performance in Space. The closer the amount of WS flow in Space reaches that of either side of Thermoelectric-Material and/or Conductors by optimizing the spatial deformed form of terminal receiving WS in Space and the distance between "sharp pointed corner of clue" facing with the surface of the steeple tip and terminal on which the surface of the steeple tip stands so as to satisfy the above 2). By the method of above devising, WS flow through the space can smoothly and effectively occur as mentioned in the paragraph 0008.

4) In the case that the amount of WS flow through a single either steeple tip or steeple in Space cannot reach that of either side of Thermoelectric-Materials and/or Conductors, many either tips of the steeples or steeples as shown in Fig. 2 can be arranged so as to enlarge that of WS flow in Space. Many either tips of the steeples or steeples are condensely arranged on the terminal releasing WS so that the effect of the enhancement factor $\beta$ greatly decreases. The shape of the surface for either the tips of the steeples or the steeples and the surface density of states of them are optimized so as for the amount of WS flow due to field emission of WS to be equal or larger than that of WS flow in the TMs and/or Conductors without Space as large as possible. Suitable distance between the ends of Space is appropriately determined in this manner.

Because of a wide temperature range in operation, in the case that the amount of WS flow in the Thermoelectric-Materials and/or Conductors without Space is equal or larger than that of WS flow of the bulk TMs and/or Conductors without Space or that WS flow through the field emission of WS due to the effect of the enhancement factor including the surface density releasing WS made from either the tips of the steeples or the steeples reaches as large as possible or enlarges more than that of WS flow of the natural bulk TMs, the contrivance means from 1) to 4) in the paragraph 0053 is applied to other Spaces in first divided the Thermoelectric-Materials and/or Conductors into two Thermoelectric-Material.

From above result, if Spaces are optimized including the shape of the electrode terminals more than one, additional energy loss, except for the emission of radiation energy loss due to the difference temperature between the surface of either the steeple tip or the steeple and "sharp pointed corner of clue" facing with the surface of the steeple tip and the surface of the steeple tip between the other facing ends to each other in each Space, can decrease drastically. In generation of electric power when the temperature difference between the high and the low temperature parts is narrow, the distance between the surface of either the steeple tip or the steeple and the "sharp pointed corner of clue" facing with the surface of the steeple tip and the surface of the steeple tip cannot be optimized as before. In this case, Bridging Space in Fig. 6 is used. In operation of cooling system external voltage and/or current are applied as occasional demands. As TCE is manufactured by above described process, even if figure of merit of the Thermoelectric-Materials is the highest, the thermoelectric performance of TCE made from them is more drastically improved. Moreover, the operation of cooling system is a reversible process of the generation of electric power so that the thermoelectric performance of TCE manufactured in above method is improved drastically even in the operation of cooling system.

Thermoelectric-Material group in Fig.12 is not necessary to be manufactured as shown in the order of number, and all the numbered Thermoelectric-Materials are not necessary to manufacture TCE. Further like Π-type modules made of a pair of different polarities that is p-type and n-type, a group of Thermoelectric-Materials such as the group of Π-type modules can be manufactured in parallel independent of the other groups so that the Π-type modules may as well be manufactured independently in parallel. In addition, many Π-type modules, which are grouped in a series, in a parallel, in the mixture combination of series and parallel or in hybrid parallel with the series of Π-type module, are taken in a system. As an example, it is expressed that the system consists of many hybrid type of Π-type modules, which are grouped in a series, in a parallel or in mixture combination of series and parallel of Π-type module, thermoelectric combination modules made of Thermoelectric-Materials except for the Π-type modules also are designed according to a scope as well as a spirit of the present invention.

As shown in Fig. 4, instead of changing relative positions between the Thermoelectric-Materials 40 and 41, of moving the terminal of either 40 or 41, in Fig. 11 WS flow stream is not scattered by the microscopic size structure 114 of good conductor for WS which is set between the Thermoelectric-Material 111 and the surface of the steeple formed on the terminal of the Thermoelectric-Material 111 and whose shape is large and surrounds than the surface releasing WS and is like figures of the surface 114, and the actuator arranged on 115 can help to move in parallel to the shape of the surface releasing WS. Superimposing alternative currents at the beginning of operation can make a voltage between both ends of Space 112 or Space 112 between the surface 114 controlled by the actuator and the surface of the steeple on the terminal 111 high level, as if Space 92 acts as a condensor space. And then the high voltage can be utilized as a trigger of the initial operation. In case that many Spaces are thermionic materials in TCE, a voltage of an aimed Space can be in high by utilizing CR or CL resonances (or oscillation).

The above explanations about enforcement forms, such as the maximization of the figure of merit for the Thermoelectric-Material, the optimized Π-type module and systems in according with the principles of the present invention are explained as a particularly fixed concrete examples such as the Thermoelectric-Material, the optimized Π-type module and systems, do not cover all the examples and are intended to limit the scope to the system precise embodiments disclosed the present invention. Modifications and/or variations from the above teachings is possible or modifications and variations resulting from implementation of the various system embodiments of the present invention are obtained. Obviously, the method for realizing TCE made from Thermoelectric-Materials having Spaces and/or Bridging Spaces according to Claims of the invention and to produce Π-type module and/or systems employ a number of embodiments forms.

In order to avoid the changes or heat retention concentration, using working substance good conductor, Thermoelectric-Material, in TCE, and the like, two pairs of polar different TCEs consisting of element Π-type module further, a plurality of Π-type modules consisting of combination in mixture of series and/or parallel or those mixture of type Π-type module, alternatively, in a module group comprising a combination of the TCEs other than the Π-type module, an example of Thermoelectric-Material comprising a Thermoelectric-Material consisting of these modules, in that the changes to heat retention concentration does not occure, is implemented by cascading Π-type modules that based on the plurality of Π-type module made of Thermoelectric-Material different in two sets of polarity. If a uniform and constant heat flow does not occur in the entire cascaded Π-type module group sandwiched between two different heat sources, and Thermoelectric-Material of different two sets of polarity sandwiching an electrode in series under high pressure, the pressure contact portion with or without integrated module members, such as fins for receiving and radiating heat and the like, or having Seebeck coefficient it is necessary to use a heat conductive material such as showing the anisotropy. are necessarily used. A combination for implementation of the cascading Π-type module group has been described as an example, obviously, however, groups of modules other than the cascading Π-type module group also exist, a specific example using the cascading Π-type is presented only for the purpose of the explanation, and then the specific example is not limitations on the claimed invention.

Any types of the actuators, the Π-type modules including cascading Π-type module and the system which are used in the explanation of the present invention must not comprehend as conclusively important or indispensable to the present invention unless otherwise stated.

By putting Space into Thermoelectric-Materials, it is a possibility that WS flow may be mainly obstructed in generation of electric power. WS is emitted from the surface 13 by using thermal energ ies in the Thermoelectric-Materials, and energies of electric fields, or external electromagnetic wa ves, etc. In the case that WS moves from the Thermoelectric-Material 11 to 10 in Fig. 1, WS in S pace is exited in the "sharp pointed corner of clue" 14 receiving WS and the surface 13 of steeple having WS of the respective Thermoelectric-Materials by thermal energy and so on, or WS there in tunnels through the potential barriers in the surfaces 13 into 12 and then moves into "sharp poi nted corner of clue" 14 receiving WS. According to macroscopic quantum mechanics, transmissi on probability of the tunnel potential barrier for WS at the surface 13 in Space decreases expone ntially as mass of WS increases, but the fluctuation is suppressed when it is operated at cryogeni c temperatures so that $L_{max}(T)$ becomes much narrower at cryogenic temperatures, and then TC E for WS with large masses may become practicable. Generally for a hole and an electron in se miconductor, mass of the hole is several times mass of the electron. As a result, when the ends of Space 12 separates widely to some extent, even in p-type semiconductor electrons tunnel thro ugh rather than holes do. In the case that Thermoelectric-Material 11 is semiconductor and that 13 is metal, junction between the terminal of the steeple and 13 being the protection member 16 which covers the steeple with metal is more desirable to be Ohmic contact in electric power gene ration and Schottky contact in operation of cooling system. Claim 7 makes it possible that an ato m and/or molecule placed in the vicinity of the interfaces to join the different members into one su pply or absorb thermoelectric conversion system, or by injecting the atom and/or molecule, that c onstitute a WS good conductor in vicinity of the interface to join the different members, the interfa ce can be built in order to match the power generation, cooling, heating operation.

For the sake of improvement of *ZT*. for TCE, a new repeating the procedure of paragraph 0053 is applied to TCE in Claims 1 and 2 as the material again, the obtained figure of merit is further improved. The above procedure repeating many times as described in Claim 8 makes it possible to create quasi Carnot TCE and/or quasi Carnot TCM and quasi Carnot Thermoelectric Conversion System with a built-in them whose figure of merits approach the Carnot efficiency. Materials in the above procedure can be used only TCEs, a segmented generation TMs which made from combination of different generation TMs or combinations of different generation TMs. The above procedure is different scales in shape or operation mechanism between generations.

In the above Claims 1 to 8, a basic system in which one of two different fixed heat source temperatures coincides or does not coincide with the ambient atmosphere temperature is dealt with. In Claim 9, however, in case that the $i$th species the $n$th generation TCM and/or the $i$th species the $n$th quasi Carnot TCM made from th $n$th generation TCE and/or the $n$th generation quasi Carnot TCE in Claims 1 to 8 work between any two different fixed heat source temperatures among three or more different fixed heat source temperatures where anyone of different fixed heat source temperatures matches matches or does not match with the temperature of the ambient atmosphere, (here $i$ = 1,2,3, $\cdots$, a natural number, when the largest $i$ is equivalent to 1, the $i$th species the $n$th generation TCE corresponds to a conventional basic system.) The temperature difference between connectors on each "end plate for connecting with the outside world system"s of either the $i$th species the $n$th generation TCM or the $i$th species quasi Carnot TCM made from the $i$th species the $n$th generation TCE or the $i$th species quasi Carnot TCE, and the temperature differences among electrodes of the current and/or voltage source or the external load and connectors on each "end plate for connecting with the outside world system" of the $i$th species the $n$th generation TCMs made from the $i$th species the $n$th generation TCE or quasi Carnot TCE are effectively used to build an optimized modulation of the upper inter-species and an optimized system of the upper inter-species. Sometimes kinds of ambient temperature is one or more than one, here, however, the ambient temperature is one only for the sake of simplicity.

**Brief Description of Drawings**

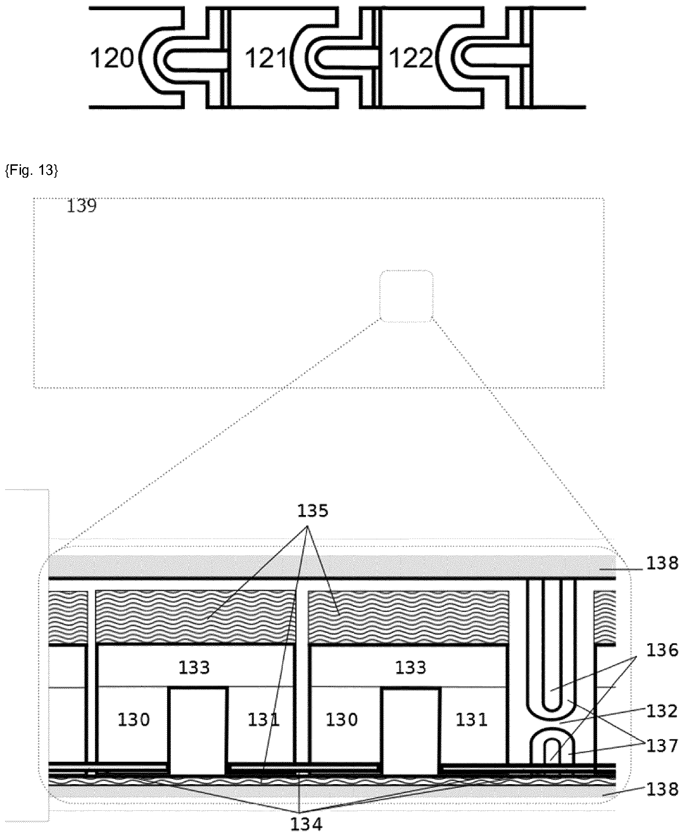

{Fig. 1}   Space containing the steeple tip (including a columnar) in the thermoelectric conversion element (TCE)
{Fig. 2}   Space containing the steeple having the clue in TCE
{Fig. 3}   Space containing pair of the steeples with different heights in TCE
{Fig. 4}   Space containing the steeple and concave surrounding over the steeple in TCE
{Fig. 5}   Space containing many of the steeple and the concave surrounding over the steeple in TCE
{Fig. 6}   Fine pillar structures having wide lateral faces A column is in a thin structure (a), a hollow cylinder (b), and a rectangular (c)
{Fig. 7}   Cross sections of bridging materials made of Fine Structure having layered structures of cylinder (a) and a rectangular (b)
{Fig. 8}   Bridging Space containing Fine Structure in TCE
{Fig. 9}   Bridging Space including plural bridging structures in TCE
{Fig. 10}   Space in TCE
{Fig. 11}   Space having the steeple on the terminal releasing WS and the surface receiving WS whose shape with similar shape the terminal releasing WS and by control of an actuator
{Fig. 12}   Spaces segmented multi-stage in TCE
{Fig. 13}   Relationship between the $i$th generation Thermoelectric-Material and the $i$ - 1th generation TCE being aimed at the series $\Pi$-type module from the $i$ - 1 th generation Thermoelectric-Materials in the infinitesimal part of the $i$th generation Thermoelectric-Material

**Description of Embodiments**

Fig. 13 shows an example in which attention is paid to a part of the $i$th generation TCE made from the series $\Pi$-type module whose legs are the Thermoelectric-Materials 130 and 131 having different polarity each other and from the Space 132 with the insulation 135. By use of an insulations possible controlled by the actuator i.e. one of the structural parts, which is omitted in FIG. 13, between the insulation material 135 and the WS good conductor 138, heat flow of heat transfer in the Thermoelectric-Material 139 is adjusted so that the laminar flow occurs. The heat of the WS good conductor 133 reaches the WS good conductor 138 passes through the insulations 135. The steeples and/or "sharp pointed corner of clue" and the like built in Space and Space can be changed for the bridging materials in Bridging Space. Radiation energy loss between the WS good conductors that face each other in Space and/or Bridging Space is much larger than the radiation energy loss of the $\Pi$-type module, it is necessary that the area ratio of the latter and the former is much smaller is there. Space and/or Bridging Space can be constructed between many pair terminals created by divisions of the legs of the series $\Pi$-type module, of course, and between the $i$ - 1th generation Thermoelectric-Material and WS good conductor.

It has secured the amount of current and voltage by use of a plurality of $\Pi$-type modules if necessary. The WS good conductor 138 in $\Pi$-type module of Fig. 13 incorporates the heat flow from the insulation 135. Here, it is needless to say that modules other than $\Pi$-type module to which has been focused are useful.

**Reference Signs List**

10            The Thermoelectric-Material or WS good conductor having the terminal receiving WS

| 11 | The Thermoelectric-Material or WS good conductor having the terminal releasing WS |
| 12 | Space |
| 13 | The surface of the tip of steeple releasing WS |
| 14 | The steeple tip receiving WS |
| 15 | The coating or thick member containing atoms and/or molecules conducting WS |
| 16 | The protective member |
| 20 | The Thermoelectric-Material or WS good conductor having the clue receiving WS |
| 21 | The Thermoelectric-Material or WS good conductor having the terminal releasing WS |
| 22 | The distanced ($d \geq L_{max}(T)$) between the steeples and/or "sharp pointed corner of clue" and the like built in Space |
| 23 | The surface of steeple tip releasing WS |
| 24 | The surface of clue receiving WS |
| 25 | The coating or thick member |
| 30 | The Thermoelectric-Material or WS good conductor having the terminal receiving WS |
| 31 | The Thermoelectric-Material or WS good conductor having the terminal releasing WS |
| 32 | The distanced ($d \geq L_{max}(T)$) between steeples and/or "sharp pointed corner of clue" and the like built in Space |
| 33 | The protective member |
| 34, 35 | The coating or thick member |
| 40 | The Thermoelectric-Material or WS good conductor having the terminal receiving WS |
| 41 | The Thermoelectric-Material or WS good conductor having the terminal releasing WS |
| 42 | Space |
| 43 | The surface of the steeple releasing WS |
| 44 | The surface of the concave terminal receiving WS |
| 50, 51, 52 | The steeple structure |
| 80 | The Thermoelectric-Material or WS good conductor |
| 81 | The Thermoelectric-Material or WS good conductor |
| 82 | Space |
| 83 | The bridging material good conducting WS |
| 84, 85 | The protective member |
| 90 | The Thermoelectric-Material or WS good conductor having the terminal receiving WS |
| 91 | The Thermoelectric-Material or WS good conductor having the terminal releasing WS |
| 92 | Space |
| 93 | Many Bridging materials good conducting WS |
| 100 | The Thermoelectric-Material or WS good conductor having the terminal receiving WS |
| 101 | The Thermoelectric-Material or WS good conductor having the terminal releasing WS |
| 102 | Space |
| 103 | The radiation source |
| 105 | The coating or thick member containing atoms and/or molecules conducting WS |
| 106 | The protective member |
| 110, 111 | The Thermoelectric-Material or WS good conductor |
| 112 | Space |
| 113 | The space between the surface of the terminal and the surface having a similar shape to the tip of the steeple |
| 114 | The surface having a similar shape to the tip of the steeple |
| 115 | The parts, in which WS can conduct, sustaining the width between the surface of the terminal and the surface having the similar shape |
| 120, 121, 122 | Elements of the thermoelectric material or WS good conductor |
| 130, 13 | The $i$ - 1th generation Thermoelectric-Material |
| 132 | Space |
| 133, 134 | WS good conductor |
| 135 | The insulatoion |
| 136 | The Thermoelectric-Material or WS good conductor |
| 137 | The protective member or thick member |
| 138 | The WS good conductor |
| 139 | The $i$th generation thermoelectric conversion element |

**Claims**

1. A thermoelectric conversion element being characterized as follow;
In case that, at least, one of members sandwiching or contacting with a space (Space) being a thermoelectric material (TM), a member whose end portion faces with TM through Space is the same TM, a different TM, an "end plate for connecting to the outside systems" or structural materials in contact with high, low heat reservoirs or the other temperature heat and/or the like all of which are covered with insulations, adiabatic materials, member parts responsible for external impact mitigation, radiation shields and/or the like contacting with at least two different heat sources such as the temperature of the ambient temperature, "distance" (i.e. $L_{max}(T)$), that depends on the constituent material, in order to block heat flow between the surfaces having different absolute temperature T facing each other across Space, in the measurement interfacial spacing that faces in the heat flow direction by taking consideration of thermal noise in the configuration with the atomic force microscope made from respective interfaces constituent materials is defined to be equal to or longer than the distance where the atomic force between atoms confronting each other in interfacial spacing, the heat flow is cut off when the distance between the surfaces having different absolute temperature $T$ facing each other across Space equals to or larger than $L_{max}(T)$ on one of interfacial material-terminals, that face in WS flow direction in Space and that are not necessarily parallel each other, the leg of either steeple or the steeple whose tip is a coil shape or a coil can be thick in accordance with any shapes of the interfacial material-terminal, on another interfacial material-terminal in facing with the interfacial material-terminal in the same manner as described above, steeple and/or "sharp pointed corner of clue" which can be thick leg, and in case that a pair, in which distance between one of the interfacial material-terminals and the other that is the convex end surface of steeple and/or "sharp pointed corner of clue", equals to or larger than $L_{max}(T)$, or more pairs exist in Space, electromotive force due to the thermoelectric material itself adjacent to Space acts on Space, and WS flow amount through Space does not change from that within the adjacent TM in contact with Space, $L_{max}(T)$ which is a distance between end points, therefore, depends on the adjacent TM, TM having Space, in which the number of pair is one or more, or more Spaces, "end plates for connecting with system of the external world", high and low heat source and/or the other temperature heat all of which face with structural parts, which are insulations, adiabatic materials, external impact mitigations, radiation shields and the like, are brought up together in the heat bath temperature of the ambient atmosphere, all at once which is defined as the thermoelectric conversion element (TCE), in TM or Space inside TCE,

(i) A polarity of WS working is either positive or negative charge, or
(ii) WS for the polarity of positive and negative charges works by an electric field, a magnetic field and/or the like outside of TCE, a further temperature gradients, WS concentration gradient, WS velocity gradient or the like in TCE are caused, by these caused gradients, classical WS, quantum WS or macroscopic quantum WS becomes mainly significant at different temperature, but in case that current and/or voltage is or is not applied from the "end plates for connecting with system of the external world" to TCE containing such WS, (A) WS exists in Space A: Electromagnetic fields to individual steeples and the like, or B: Magnetic field perpendicular a plane made from WS flows of adjacent two steeples whose WS are mutually different polarity or the same polarity, or C: The above-mentioned A and B simultaneously possible drive WS, in addition to the above-mentioned (A), further (B) Magnetic field vertical to TM adjacent to Space can control WS flows, In case that WS working passes through inter-terminal distance of Space either between the surface of "either the steeple tip (or clue) or the steeple" and its facing either terminal or clue, or between facing clues, temperature limits of WS working in either classical in some TMs or quantum system in other TMs are determined and those of WS working in macroscopic-quantum system being in facing materials which are placed apart each other at inter-terminal distance are also determined in each material, than the value of dimensionless figure-of-merit $T$ which is determined from TM used in wide or all over temperature limits which range from those of the classical system either to those of the quantum system or to those of the quantum system and the macroscopic-quantum system, the wide or all over temperature limits are disjointed into some temperature limits for each segmented thermoelectric material in which respective each thermoelectric material being in the highest value of $ZT$, the value of $ZT$ for the thermoelectric material in case of combining many segmented thermoelectric materials into one in improved, the value of $ZT$ for the segmented thermoelectric material in case of combining many thermoelectric materials into one as TCEs with Space is further improved than that of $ZT$ for the segmented thermoelectric material without Space, and Space, moreover, makes damages due to thermal stress and/or diffusion mixing of matter, solder material and the like in use decrease, due to WSs passing through the above described facing surfaces in Space made from TM and so on, emission and/or absorption thermal energies, distribution of WS momentum parallel to the direction of WS flow stream and/or variation of spin distribution in the facing surfaces can be utilized

2. A thermoelectric conversion element being characterized as follow;
In case that, at least, one of members that sandwich or contact with Space is TM, and the electromotive force of TM itself is less than the TM according to Claim 1, because that a spacing in Space made of TM equals to or wider than $L_{max}(T)$ determined by the TM according to Claim 1, the heat flow in Space is blocked, at the temperature range wherein, at least, one of WS in TM that faces in Space works in classical WS or quantum WS, and in order for amount of WS flow through Space to equal to or more than that of TM in contact with Space whose distance between inter-faces is in the $L_{max}(T)$ or more of a distance in the direction of WS flow, Bridging Space constructed by bridging across Space with a bridging material whose each leg, connected with terminal, can be thick in accordance with any shapes of inter-surface for terminal, Bridging Space having one or more bridging material can suppress heat flow due to lattice vibrations at inter-face between the bridging materials and the inter-surface of terminal and in the bridging materials, using the bridging materials whose length is longer than $L_{max}(T)$, the amount of WS flow through Bridging Space can be much more than that of Space TM in which the number of Bridging Space is one or more, "end plates for connecting with system of the external world", high and low heat source and/or the other temperature heat all of which face with structural parts, which are insulations, adiabatic materials, external impact mitigations, radiation shields and the like, are brought up together in the heat bath temperature of the ambient atmosphere, all at once which is defined as the thermoelectric conversion element (TCE) as described in Claim 1, electric and magnetic field are applied near the bridging materials, in place of the steeple and so on at (A) and (B) described in Claim 1, and TCE also includes zero or more than one Space of Claim 1, as described in Claim 1, the figure-of-merit for TCE is larger than that for TM itself, the segmented thermoelectric material without Bridging Space , and moreover damages due to thermal stress and/or diffusion mixing of matter, solder material and the like in use decrease, due to WSs passing through the above bridging material described facng surfaces in Space (i.e. Bridging Space), emission and/or absorption thermal energies, distribution of WS momentum parallel to the direction of WS flow stream and/or variation of sipn distribution in the facng surfaces can be utilized.

3. Radiation and electromagnetic waves are possible to irradiate on at least one of the convex end surface of steeple from which WS flows into a terminal and its facing terminal, on which the leg of the steeple stands, in at least one of Spaces in TCE as described in Claim 1, or on at least one of the leg of the bridging materials in at least one of Bridging Spaces and the terminal supplying WS to the leg in TCE as described in Claim 2, in order to cut off heat flow through the radiation source and/or the electromagnetic wave source which are equipped with a position that the distance between which also serves as the drive and the control in (A) and (B) as described in Claims 1 and 2 and both the irradiated terminals and so on and a nonirradiated ones is larger than $L_{max}(T)$, because that amount of WS flow in TM in contact with Space and/or Bridging Space equipped with these ray sources equals to or more than that without these ray sources, TCE **characterized by** increasing the amount of WS flow than that in the absence of devising ray source leads to reduce the thermal conductivity.

4. In case that the entire surface of both terminals joined to the legs of steeple in Space in Claim 1, and interface and/or steeple and/or the convex end surface of steeple and/or "sharp pointed corner of clue" which face with the terminals, and the terminals facing with bridging materials whose legs stand on the terminals in Bridging Space in Claim 2, is covered with coating including atoms and/or molecules of WS good conductors and/or a thick member, and that the distance between the surfaces of the coating and/or the thick member and those of opposed to the former surfaces and/or the convex end surface of steeple equals or wider than $L_{max}(T)$, due to the drive and the control in (A) and (B) as described in Claims 1 and 2, or the irradiation of radiation and electromagnetic waves in Claim 3, preventing the accumulation of localized charge and/or WS in Space or Bridging Space leads to TCE **characterized by** comprising the coating and/or the thick member in Space or Bridging Space.

5. By the radiation and electromagnetic field irradiating damages for steeples and the like in Space, for the surface of bridging materials and the facing terminals with which the bridging materials connect each other in Claims 1, 2 and 3 and for the coating and /or the thick member in Claim 4, WS excitation and/or the damages for the steeple and the like and/or for the surface of bridging materials and/or for the coating on the terminals and/or for the thickness of coating do not occur by use of protective members, whose forces between their constitutional atoms are stronger than those of the uncoating or ununiting surface or in which cooperative motions, absorb the vibration of the surface of protective members from which the protective members are joined to the facing terminal in the $L_{max}(T)$ .or more, TCE **characterized, in that** WS flows through the steeple and the like and/or the bridging materials in large amounts of WS in Claims 1 and 2 without excitation and irradiation damages of Claims 1 and 2 or without those for the coating and /or the thick member in Claim 4, reduces less degradation due to preventing from concentration of heat on the surface and the amount of energy obtained per unit time.

**6.** The segmented TCE, the segmented TCM and TCS with a built-in them with the movable portions being characteristic of adjusting much more easily to each operation than that without the movable portions having:

in Space in TCE in Claim 1 taken with or without the devices in Claims 3, 4 and 5 into account, by use of TCE in which a movable portion, which is easily controlled, is placed with $L_{max}(T)$ as described in Claim 4 or more wider, the movable portion moving in Space can change TCE between Ohmic contact and Schottky contact, can make a tunnel between two adjacent quantum WSs to each other in TCE occur and an overlap degree of two adjacent macroscopic quantum WS order parameters change including zero in TCE, in not only a narrow temperature range but also a wide temperature range, of course, power generation until the extensive, cooling, corresponding to heating, at least two of power generation, cooling and heating operation, the movable portion movement makes TCE possible to work, in a wide temperature range, moreover, a segmented TCE made from TCE equipped with movable portions in Space and/or near "end plates for connecting with system of the external world" of TCE as described in Claim 1, Claim 3, Claim 4 and Claim 5 which includes the feature that integrated modules, which are made from TCE and/or Π-type modules and/or the other modules except for the Π-type modules and/or the like, reduce the member materials usage such as insulations, adiabatic materials, external impact mitigation, radiation shield and so on, and another feature that easy to make TCS with a built-in them, the segmented TCE, the segmented TCM and TCS with a built-in them with the movable portions are characteristic of adjusting much more easily to each operation than that without the movable portions.

**7.** TCE in Claim 1, Claim 3, Claim 4 and Claim 5 and/or TCM and TCS with a built-in them in Claim 6 being characterized as follows; at the entire surface of convex end surface of steeple in TCE as described in Claim 1 and at the entire surface of interface and/or steeple and/or convex end surface of steeple and/or "sharp pointed corner of clue" which face with the convex end, or at the entire surface of "end plates for connecting with system of the external world" and at the entire surface for either junction surface of WS good conductors of TCE, or that of Π-type modules and modules with a built-in them which face with the entire surface of "end plates for connecting with system of the external world", the entire surface of the convex end surface of steeple and that of "end plates for connecting with system of the external world", and the interface and/or steeple and/or the convex end surface of steeple and/or "sharp pointed corner of clue" which face with the convex end and the entire surface for either junction surface of WS good conductors of TCE, or that of Π-type modules and modules with a built-in them are defined as the former and the latter, respectively, supplying or absorbing WS to either the former or the latter or to both of the former and the latter, or depending on the concentration of the atoms and/or molecules and the like absorbing the vibration of the surface in response to the operating temperature range and near the junction surfaces of the former connecting with the latter, because that connectors on the former and/or the latter are constructed in order for the amount of WS concentration among Ohmic junction or Schottky junction, the quantum WS tunnel effect and overlapping of macroscopic quantum WS order parameter to make the respective junction be in the best WS concentration independently, the connectors are also constructed in the distance between any two of the connectors in which interferences does not occur due to these connectors being apart from each other, or the coating and /or the thick member in Claim 5, wherein to eliminate the interference,

(i) these connectors on the surface, such as the convex end surface of steeple and/or "sharp pointed corner of clue" of the latter that faces the convex end surface of steeple, are constructed, and over the convex end surface of steeple for the former, the devices of (A)-a in Claim 1 or the movable portion in Claim 6 in response to the operating temperature range, the connectors constitute a characteristic feature that the extent among Ohmic junction or Schottky junction, the quantum WS tunnel effect and overlapping of macroscopic quantum WS order parameter is easily adjusted,

(ii) TCE and/or Π-type modules and/or upper modules with a built-in them, in which a plural number of connectors on "end plates for connecting with system of the external world" of the latter are constructed and connect with each connector on the junction surfaces of WS good conductors, respectively, work on power generation, cooling and heating operation, by use of recombinantly wiring to match the respective generation and operations, TCE in Claim 1, Claim 3, Claim 4 and Claim 5 and/or TCM and TCS with a built-in them in Claim 6 have the recombinantly wiring to match the respective generation and operations.

**8.** The nth generation TCE and/or the nth generation TCM and thenth generation Thermoelectric-Material with a built-in them and/or thenth generation TCS being obtained, or furthermore after an infinite number of times for the procedures, quasi Carnot TCE or quasi Carnot TCM whose efficiency close to the Carnot efficiency and/or quasi Carnot TCS with a built-in them being characterized as follow;

for the sake of improvement in the figure-of-merit for TCE in Claim 1, Claim 2, Claim 3, Claim 4 and Claim 5 and/or for TCM in Claim 6 and Claim 7, thermoelectric materials (TMs) containing no TCE in Claims 1 and 2 and their figure-of-merit for TM in TCE and TCM are defined as 0th generation TMs and $Z_0 T$, respectively, 0-a) TCE in Claim 1 or TCE in Claim 2 because the electromotive force of TM in TCE is small, 0-b) TCE in Claims 3, 4 and 5 and/or TCM in Claims 6 and 7 are defined as 0th generation TCE and/or 0th generation TCM respectively, 0-c) an aggregation made from plural of the 0th generation TCEs and/or the 0th generation TCMs and WS good conductors, insulations, the 0th generation TMs and so on is defined as 1st generation Thermoelectric-Material (as defined in Background Art), and then the figure-of-merit for the 1 st generation Thermoelectric-Material will replaced with $Z_1 T$ and $Z_1 T > ZT$ is obtained, moreover, by more repeating the procedure of the above 0-a) $\sim$ 0-c) again, 1-a) 1st generation TCE in Claim 1 or 1st generation TCE in Claim 2 because the electromotive force of Thermoelectric-Material in TCE is small, 1-b) TCE in Claims 3, 4 and 5 and/or TCM in Claims 6 and 7 are defined as 1 st generation TCE and/or 1 st generation TCM, respectively, 1-c) an aggregation made from plural of the 1st generation TCE and/or the 1st generation TCM and WS good conductor, insulations, the 0th generation Thermoelectric-Material and so on is defined as the 2nd generation Thermoelectric-Material, and then ZT for the 2nd generation Thermoelectric-Material will be replaced with $Z_2 T$, $Z_2 T > Z_1 T$ is obtained and after more repeating this procedure as 3,···,n times, thenth generation TCE and/or the nth generation TCM and thenth generation Thermoelectric-Material with a built-in them and/or the nth generation TCS being obtained, or furthermore after an infinite number of times for the procedures, quasi Carnot TCE or quasi Carnot TCM whose efficiency close to the Carnot efficiency and/or quasi Carnot TCS with a built-in them

9. The $i$th species thenth generation TCM and/or quasi Carnot the$i$th species TCM, which consist of the $i$th species the nth generation TCE and/or quasi Carnot TCE that is the basic system in Claims 1, 2, 3, 4, 5, 7 and 8, using the temperature difference between the electrodes of the current and/or voltage source or the external load and the connectors on "end plate for connecting to the outside world of the system", and the$i$th species thenth optimized generation TCM and/or quasi Carnot optimized the$i$th species TCM and the optimized TMS with a built-in them which consist of the$i$th species thenth optimized generation TCE and/or quasi Carnot the$i$th species optimized TCE being characterized as follows:

In the above Claims 1 to 8, a basic system in which one of two different fixed heat source temperatures does or does not coincide with the ambient atmosphere temperature is dealt with, here, however, in case that the $i$th species the nth generation TCM and/or quasi Carnot the $i$th species TCM made from the $i$th species thenth generation TCE and/or quasi Carnot the$i$th species TCE in Claims 1 to 8 work between any two different fixed heat source temperatures among three or more different fixed heat source temperatures furthermore, one of the two different fixed heat source temperatures matches matches or does not match with the temperature of the ambient atmosphere, (here $i = 1, 2, 3, ···$, a natural number, when the largest $i$ is equivalent to 1, the 1st species the nth generation TCE corresponds to the conventional basic system including Claims 1 and 2), in process of an upper level modulation among the$i$th species, and in case that temperatures of the "end plate for connecting with the outside world system" of other TCEs and/or TCMs for the$i$th species the nth generations to be connected in the process are all same and different from one or more than the temperatures of the "end plate for connecting with the outside world system" of either the$i$th species thenth generation TCM or quasi Carnot the $i$th species TCM, whose "end plate for connecting to the outside world of the system" connects with any two different of the foregoing fixed heat sources through the insulations contacting and/or one or more non-contacting with any of the two foregoing fixed heat sources, at different temperatures from at least one or more than the temperatures, connectors, on each "end plate for connecting to the outside world of the system" of the$i$th species thenth generation TCM and/or the $i$th species quasi Carnot TCM made from more of the $i$th species thenth generation TCE and/or quasi Carnot the$i$th species TCM, are defined as the connectors between the upper level of the species modules, and other connectors, on each "end plate for connecting to the outside world of the system" of the$i$'th species thenth generation TCM or quasi Carnot the $i$'th species thenth generation TCM consisting of the $i$'th species the nth generation TCEs or quasi Carnot the $i$'th species thenth TCEs which have the$i$'th species different from the$i$th species at temperature different from the temperature of the connectors in the $i$th species, are defined as the upper level of modulation connectors between the $i$th and the $i$'th species, for the connectors, the other connectors and the obtained connectors of the upper level, respectively, the modulation between the connectors and the other connectors of the $i$th and the $i'$th species as described in the above (i), in case that the connectors, on "end plate for connecting with the outside world system" of the $i$th species the $n$th generation TCE and/or the $i$th species the $n$th generation TCM and/or quasi Carnot the $i$th species TCM including, are those for the current and/or voltage source and/or an external load, and in case that the temperatures of the connectors equal to one of or do not equal to any one of the environmental atmosphere temperatures, in which electrodes of the current and/or voltage source or the external load are placed, certain different temperatures in thermal baths and the like, the $i$th species the $n$th generation TCM and/or quasi Carnot the $i$th species TCM, which consist of the $i$th species the $n$th generation TCE and/or quasi Carnot TCE that is the basic system in Claims 1, 2, 3, 4, 5, 7 and 8, use the temperature difference between the electrodes of the current and/or voltage source or the external load and the connectors on "end plate for connecting to the outside world of the system", and the $i$th species the $n$th optimized generation TCM and/or quasi Carnot optimized the $i$th species TCM and the optimized TMS with a built-in them which consist of the $i$th species the nth optimized generation TCE and/or quasi Carnot the $i$th species optimized TCE

{Fig. 1}

{Fig. 2}

[Fig. 3}

{Fig. 4}

[Fig. 5}

[Fig. 6}

a  b  c

[Fig. 7}

a  b

{Fig. 8}

{Fig. 9}

{Fig. 10}

{Fig. 11}

{Fig. 12}

{Fig. 13}

## INTERNATIONAL SEARCH REPORT

| International application No. |
| --- |
| PCT/JP2015/072812 |

**A. CLASSIFICATION OF SUBJECT MATTER**
*H01L35/32*(2006.01)i, *H01L37/00*(2006.01)i, *H02N11/00*(2006.01)i

According to International Patent Classification (IPC) or to both national classification and IPC

**B. FIELDS SEARCHED**

Minimum documentation searched (classification system followed by classification symbols)
H01L35/32, H01L37/00, H02N11/00

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>A | WO 2014/030264 A1 (Mahito MABUCHI),<br>27 February 2014 (27.02.2014),<br>column 6, line 21 to column 12, line 25; fig. 1<br>to 12<br>& US 2015/0207055 A1<br>paragraphs [0047] to [0079]; fig. 1 to 12<br>& EP 2889925 A1 | 1-6<br>7-9 |
| A | JP 2004-515924 A (International Business<br>Machines Corp.),<br>27 May 2004 (27.05.2004),<br>& EP 1340266 A2        & CN 1478307 A<br>& WO 2002/047176 A2    & US 2002/0166839 A1<br>& KR 10-0558800 B1 | 1-9 |

| ☒ | Further documents are listed in the continuation of Box C. | ☐ | See patent family annex. |
| --- | --- | --- | --- |

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 26 October 2015 (26.10.15) | 02 November 2015 (02.11.15) |

| Name and mailing address of the ISA/ | Authorized officer |
| --- | --- |
| Japan Patent Office<br>3-4-3,Kasumigaseki,Chiyoda-ku,<br>Tokyo 100-8915,Japan | |
| | Telephone No. |

Form PCT/ISA/210 (second sheet) (July 2009)

**INTERNATIONAL SEARCH REPORT**

| International application No. |
|---|
| PCT/JP2015/072812 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2011-222654 A  (Yoshiomi KONDO),<br>04 November 2011 (04.11.2011),<br>(Family: none) | 8-9 |

Form PCT/ISA/210 (continuation of second sheet) (July 2009)

## REFERENCES CITED IN THE DESCRIPTION

**Patent documents cited in the description**

- JP 2011057202 A
- WO 201430264 A1
- JP H955542 B
- JP H1027927 B
- JP H1041554 B
- JP 2007246326 A
- JP 2011067202 A
- WO 20143264 A1

**Non-patent literature cited in the description**

- **K. KUROKI ; R.ARITA.** *J. Phys. Soc. Jpn,* 2007, vol. 76, 083707
- **JUNICHI TAKAHASHI.** Scientific Research Grant Program (Grant-in-Aid for Scientific Research). *Research Report Form C-19,* 18 May 2012
- **NAOOKI YAMADA ; SATOSHI TAGA.** *comprehensive engineering,* 2012, vol. 24, 10-16
- **KAMRAN BEHNIA et al.** *Phys. Rev. Lett.,* 2007, vol. 98, 076603
- *Phys. Rev. Lett.,* 2007, vol. 958, 166602
- *Science,* 2007, vol. 317, 1729
- **RYOEN SHIRASAKI.** Fundamental Relation Between Transport Coefficients in Quantum Hall System. *Yukawa International Seminars,* 2007
- **YUYA SAKURABA ; KOTA HASEGAWA ; MASAKI MIZUGUCHI ; TAKAHIDE KUBOTA ; SHIGEMI MIZUKAMI ; TERUNOBU MIYAZAKI ; KOKI TAKANASHI.** Anomalous Nernst Effect in an L10-FePt/MnGa Thermopiles for New Thermoelectric Applications. *Applied Physics Express,* 2013, vol. 6, 033003
- *Phys. Rev. B,* 1993, vol. 47, 16631
- *Jpn. J. Appl. Phys.,* 2008, vol. 47, 2005
- **M. AKASAKAA ; T. LIDA ; T. NEMOTO ; J. SOGA ; J. SATO ; K. MAKINO ; M. FUKANO ; Y. TAKANASHI.** *Journal of Crystal Growth,* 2007, vol. 304, 196-201
- **TOYAMA, A. YAMAMOTO ; H. HAZAMA ; R. ASAHI.** *Mater. Trans.,* 2010, vol. 51, 1127-1135
- **T. J. ZHU ; F. YAN ; X. B. ZHAO ; S. N. ZHANG ; Y. CHEN ; S. H. YANG.** *J. Phys. D: Appl. Phys.,* 2007, vol. 40, 6094-6097
- **ISODA, Y. ; NAGAI, T. ; FUJIU, H. ; IMAI, Y. ; SHINOHARA Y.** Proceeding of ICT' 07 2008. IEEE, 251
- **FEDOROV, M. I. ; ZAITSEV, V. K.** Thermoelectrics Handbook. Macro to Nano. CRC press. Taylor & Francis group, 2006, 31-1, 31-19
- **POUDEL, B. et al.** High-Thermoelectric Performance of Nanostructured Bismuth Antimony Telluride Bulk Alloys. *Science,* May 2008, vol. 320 (5876), 634-638
- *Jpn.J. Appl. Phys.,* 2009, vol. 48, 098006
- *Appl. Phys.,* 1962, vol. 33, 2917
- **J.-P.FLEURIAL ; G.J.SNYDER ; J.A.HERMAN ; P.H.GIAUQUE ; W.M.PHILLIPS ; M.A.RYAN ; P.SHAKKOTTAI ; E.A.KOLAWA ; M.A.NICOLET.** *18th International Conference on Thermoelectrics,* 1999
- Development of the Cascade module. Foundation Engineering Advancement Association, October 2005
- **OTA MINORU.** *Development Japan Thermoelectric Society of highly efficient thermoelectric conversion system magazine,* October 2007, vol. 4 (4), 15-17